(19) **Europäisches Patentamt**

**European Patent Office**

**Office européen des brevets**

(11) **EP 0 375 097 B1**

(12) # EUROPEAN PATENT SPECIFICATION

(45) Date of publication and mention
of the grant of the patent:
**10.12.1997 Bulletin 1997/50**

(51) Int. Cl.[6]: **B29C 39/42**, B23K 26/00,
G01J 1/42

(21) Application number: **89303780.4**

(22) Date of filing: **17.04.1989**

(54) **Stereolithographic beam profiling**

Profilierung eines Strahlungsbündels für Stereolithographie

Profilage d'un faisceau de rayonnement pour la stéréolithographie

(84) Designated Contracting States:
**AT BE CH DE ES FR GB GR IT LI LU NL SE**

(30) Priority: **08.11.1988 US 268816**
**08.11.1988 US 268837**
**08.11.1988 US 268907**
**08.11.1988 US 269801**
**18.04.1988 US 182830**

(43) Date of publication of application:
**27.06.1990 Bulletin 1990/26**

(60) Divisional application:
**96120757.8**

(73) Proprietor: **3D SYSTEMS, INC.**
**Valencia California 91355 (US)**

(72) Inventors:
• **Spence, Stuart Thomas**
**South Pasedena California 91030 (US)**
• **Almquist, Thomas**
**San Gabriel California 91775 (US)**
• **Tarnoff, Harry L.**
**Van Nuys California 91411 (US)**

(74) Representative:
**Frohwitter, Bernhard, Dipl.-Ing.**
**Patent- und Rechtsanwälte**
**Bardehle . Pagenberg . Dost . Altenburg .**
**Frohwitter . Geissler & Partner**
**Galileiplatz 1**
**81679 München (DE)**

(56) References cited:
**EP-B- 0 148 138          US-A- 4 575 330**

• **APPLIED OPTICS, vol. 17, no. 17, September 1978, pages 2673-2674; P.J. SHAYLER: "Laser beam distribution in the focal region"**
• **IDEM**
• **PATENT ABSTRACTS OF JAPAN, vol. 12, no. 2 (P-652)[2849], 7th January 1988; & JP-A-62 163 933 (NIPPON KOGAKU K.K.) 20-07-1987**
• **IDEM**
• **REVIEW OF SCIENTIFIC INSTRUMENTS, vol. 54, no. 7, July 1983, pages 856-860; J. T. KNUDTSON: "Laser beam spatial profile analysis using a two-dimensional photodiode array"**
• **Reprint from Lasers & Applications, Aug.1985, pages 65-69, D.G. Tweed, "Linearizing Resonant Scanners"**
• **OPTICAL ENGINEERING, JULY/AUGUST 1974; pages 331-334; "Anamorphic Laser Beam Shaper with a Phase Step"**
• **LASER FOCUS / ELECTRO-OPTICS; MAY 1987; page 78**
• **Reprint from PROCEEDINGS OF SPI - The International Society for Optical Engineering; Vol. 390; Jan. 20-21, 1983; pages 70-78 and cover page; K. Pelsue, "Precision, post-objective, two-axis, galvanometer scanning"**

Remarks:
Divisional application 96120757.8 filed on 23/12/96.

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

Field of the Invention

This invention relates to an apparatus and a method for determining the location of a reaction means of a stereolithographic apparatus and to an apparatus and a method for profiling a reaction means of a stereolithographic apparatus.

Background of the Invention

In recent years, "stereolithographic" systems, such as those described in U.S. Pat No. 4,575,330 entitled "Apparatus For Production Of Three-Dimensional Objects By Stereolithography" have come into use. The disclosure of U.S. Pat. No. 4,575,330 is hereby incorporated by reference, as if fully set forth herein. Basically, stereolithography is a method for automatically building complex plastic parts by successively printing cross-sections of photocureable polymer or the like on top of each other until all of the thin layers are joined together to form a whole part. With this technology, the parts are literally grown in a vat of liquid plastic. This method of fabrication is extremely powerful for quickly reducing design ideas to physical form and for making prototypes.

Photocurable polymers ("photopolymers") change from liquid to solid in the presence of light and their photospeed with ultraviolet light (UV) is fast enough to make them practical for model building materials. The material not polymerized when a part is made is still usable and remains in the vat as successive parts are made. An ultraviolet laser may be used which generates a small intense spot of UV light. This spot is moved across the liquid surface with a galvanometer X-Y mirror scanner. The scanner is driven by computer generated vectors or the like. Precise and complex patterns can be rapidly produced with this technique.

The laser scanner, the photopolymer vat, and an elevator, along with a controlling computer, combine together to form a stereolithography apparatus, referred to as an "SLA". An SLA is programmed to automatically make a plastic part by "drawing" one cross-section at a time and building it up layer by layer.

Stereolithography represents an unprecedented way to quickly make complex or simple parts without tooling. Since this technology depends on using a computer to generate its cross-sectional patterns, a natural data link to CAD/CAM exists.

To be effective, a stereolithography system must have information about the focus, laser beam oscillation mode, beam power, intensity distribution or profile, and scanning system drift of the drawing laser in order to carry out the accurate and efficient production of parts (objects made by stereolithography are known as "parts"). The beam must be in relative focus at the surface of the working photopolymer fluid. The laser mode, intensity distribution, and beam power are important to the depth and width of cure of the working fluid, as well as the scan speed. The "drift" of the scanning system must be measured and corrected periodically.

Beam profile (a profile of the intensity of the beam) measurements provide useful information about the beam because they can help accomplish the following purposes: 1. Focus optics and correct astigmatism and other aberrations; 2. Measure the power of the beam (needed on a day to day basis); 3. Study the laser mode and changes of the mode; 4. Compensate for drift of the laser scanning system; 5. Allow recording of the drift for later analysis of changes; 6. Automatically calibrate the scanners; 7. Allow easy control of beam position for making other measurements (e. g. to independently measure the beam power in order to find the system's power calibration factor) and 8. permit the prediction of the size and shape of the cured plastic trace.

From the article "Laser beam distribution in the focal region" APPLIED OPTICS, Vol. 17, No. 17, September 1, 1978, pages 2673 and 2674 an experimental arrangement is known, allowing the measurement of the intensity distribution of a focused laser beam. The arrangement consists of a focusing lens transmitting the laser beam through a pinhole, and a photodiode mounted behind the pinhole. The photodiode and the pinhole are, in turn, mounted on a stage which may be displaced in three orthogonal directions, to allow a record of the intensity distribution of the laser beam across its cross section.

From JP-A-62-163 933 another apparatus is known for measuring the intensity distribution of a laser beam. The apparatus consists of a first light shielding means having a pinhole set vertically to the optical axis of the laser beam, a light attenuating means placed therebehind, a second shielding means placed therebehind, and a photodiode receiving the light passing through the pinhole of the second light shielding means. Finally, a moving stage is provided for displacing the afore-mentioned elements vertically to the optical axis. With such an arrangement, a desired attenuation can be obtained by varying the combination of the bore diameters of the pinholes or adjusting the distance between the first light shielding means and the light attenuating means.

Another prior art approach for obtaining the spatial characterization of a laser beam is described in an article "Laser beam spatial profile analysis using a two-dimensional photodiode array", REVIEW OF SCIENTIFIC INSTRUMENTS, Vol. 54, No. 7, July 1983, pages 856 - 860.

Accordingly, the use of an imaging device is proposed, consisting of a two-dimensional array of detector elements which independently respond to visible light and are accessed serially by appropriate read-out electronics. The beam under investigation is rastered across the detector area, to provide the spatial profile of the beam in the plane perpendicular to the direction of propagation.

In an article "Linearizing Resonant Scanners", from LASERS & APPLICATIONS, August 1985, pages 65 - 69, several methods of linearizing resonant scanners are discussed. In conjunction with digital linearizers, it is proposed to place a "start-of scan (SOS) sensor" in the image plane of the scanner outside the active user area but within the minimum scanner deflection amplitude. The SOS detector consists of a split-cell photodetector whose outputs are compared to a fixed external level and each other. According to another embodiment discussed, also the provision of an "end of scan" (EOS) detector is proposed. The detectors are used for issuing start and end signals for a scanning sequence of the scanner.

From EP-B-0 148 138 a method and a system are known for calibrating a transducer system being useful in component assembly machines, drilling machines, pointing systems and draughting machines. The positioning system includes a control means adapted to send command signals intended to activate the positioning means for locating an object (e. g. a scanner) in relation to an operating area having a portion thereof defined as a working surface. In addition thereto, means are provided (i.e. transducers), for sensing the orientation of the scanner, for obtaining an actual value signal which can be utilized by the control means. To calibrate the transducer, the deflected light beam is directed to the operating area where a number of holes are provided with a known angular separation, under each of which a light sensitive detector is placed. The control computer sends commands to the scanner and receives output signals from the transducer and interprets the light intensity incident on the detectors. On the basis of the data thus available, the control computer calibrates the transducer at suitable intervals by allowing the beam to scan the detectors.

In view of the above, it is the object of the present invention to provide apparatus and methods to rapidly determine the profile of a beam in a stereolithographic apparatus, and to calibrate and normalize a stereolithographic apparatus and to correct for the drift of the mirror positioning system thereof.

These objects are solved by the apparatus in accordance with claims 1 and 2 and the methods of claims 21 and 22. Particular embodiments of the invention are disclosed in the dependent claims respectively.

In more detail, the present invention provides an apparatus and a method for profiling a beam. The apparatus comprises means for measuring the intensity of a portion of the beam when the beam is incident on the measuring means and means for changing the relative perpendicular displacement of the measuring means from an optical path followed by the beam in order to measure the intensity of some or all portions of the beam along a surface substantially perpendicular to the optical path followed by the beam. The method for profiling a beam comprises the step of measuring the intensity of a crosssectional portion of preselected size of the beam along a surface substantially perpendicular to the optical path followed by the beam and repeating the measuring step for other portions of the beam along the surface. The measuring means are mounted at a location defined by the surface of the working medium of the stereolithographic apparatus.

The apparatus and the method develops an intensity map of the beam along a surface substantially perpendicular to the optical path followed by the beam. The intensity map gives the intensities for each of the portions of preselected size of the cross-section of the beam. The intensity profile so gained can be used to determine and adjust the focus of the beam as well as to calculate the power of the beam (given a known power conversion factor). The profile of the beam may be used to predict the cure depth and width of plastic created on the working fluid. The beam profiling apparatus may be used to detect drift of the apparatus that scans the beam, by serving as a fixed reference point and determining the scanning apparatus coordinates of the center of the beam, which can be used to recalibrate the positioning "map" or table that directs the scanning apparatus in translating computer generated designs to actual dimensions on the surface of the fluid that solidifies to form the object.

The presently preferred version of the beam profiling system has a significant advantage of economy because it uses the computing system and light-beam positioning system which are already present in the stereolithographic apparatus. Although the present system refers to "laser beam" and "X-Y galvanometer scanning system" it is apparent that these advantages also apply to other possible systems with different energy sources or positioning means or combinations of these.

The present invention also provides a related new and improved apparatus and method for determining the location of a reaction means of a stereolithographic apparatus on a designated surface of a working medium. The apparatus and method is useful for normalizing and calibrating the stereolithographic apparatus and for correcting the drift of a mirror positioning system thereof.

In an apparatus for the production of parts by stereolithography, it is useful to have an apparatus and a method for normalizing and calibrating the projection of the reaction means (in a preferred embodiment, a laser beam) upon a working medium (in a preferred embodiment, a designated surface of a photopolymer). Accurate positioning of the reaction means upon the working medium is made possible according to the present invention by providing at least one sensor capable of being positioned at or in proximity to the designated surface of the working medium. The sensor is sensitive to the presence of the reaction means. In a preferred embodiment memory means are provided to store information which includes the positioning information which causes the reaction means to be pointed accurately at the sensor, and a memory look-up table or map is prepared containing specific positioning information for each of a number of specific locations on the surface of the working medium. A standard linear interpolation technique is utilized to determine positioning information useful to point the reaction means at points intermediate to those in the look-up table.

Thermal effects, wear effects and other effects can cause the positioning means for positioning the reaction means to "drift" so that the reaction means can no longer be repeatably directed to the same location. Such drift errors are also alleviated by the above apparatus and method. Preferably, a memory means is again utilized to contain past sensor location information which includes a prior apparent location of said sensor means. Means for comparing said current sensor location information and said past sensor location information is provided and is capable of determining a drift correction for use in adjusting the positioning means so as to eliminate drift error effects in the pointing of the reaction means.

The above and other objects and advantages of this invention will be apparent from the following more detailed description when taken in conjunction with the accompanying drawings of illustrative embodiments.

Brief Description of the Drawings

FIGS. 1, 2 and 3 are flow charts illustrating the basic concepts employed in practicing the method of stereolithography;
FIG. 4 is a combined block diagram, schematic and elevational sectional view of a stereolithography system;
FIG. 5 is a block diagram of a stereolithography system;
FIGS. 6 and 7 are exploded perspective views of the major component groups in a stereolithography system;
FIG. 8 is a perspective view of the laser and optical system in a stereolithography system which utilizes the preferred embodiment of the present invention;
FIG. 9A is a cross-sectional schematic view of a beam profiler sensor of the preferred embodiment of the present invention;
FIG. 9B is a top plan view of a pinhole plate for a beam profiler sensor of the preferred embodiment of the present invention;
FIG. 10 is a block diagram showing the apparatus of a preferred embodiment of the present invention;
FIG. 11A is a functional block diagram of the preferred embodiment of the method of generating an intensity profile of a beam according to the present invention;
FIG. 11B is a functional block diagram of a method of moving a beam in carrying out the method described in FIGURE 11A;
FIG. 11C is a functional block diagram of a method of reading the intensity of a portion of a beam in carrying out the method described in FIG. 11A;
FIG. 12 is a functional block diagram showing process and analyses which may be coupled with the method described in FIG. 11A;
FIG. 13 is a chart showing a sample intensity profile for a beam generated by a preferred embodiment of the invention;
FIG. 14 shows predicted cure depth profiles along two axes generated from beam profile information from a preferred embodiment of the present invention;
FIG. 15 depicts a cross-section of a cured photopolymer trace caused by exposure to a beam;
FIG. 16A depicts a perspective view of a calibration plate; and
FIG. 16B depicts a cross-sectional elevation of a calibration plate.

Description of the Preferred Embodiment

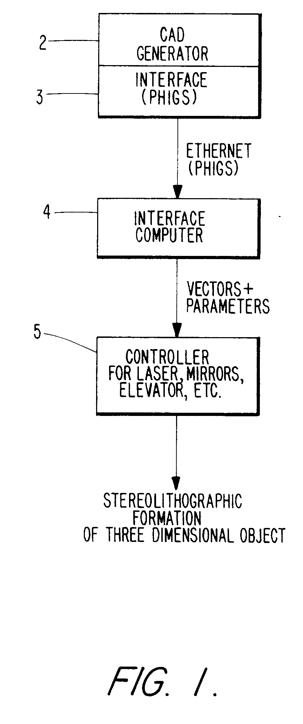

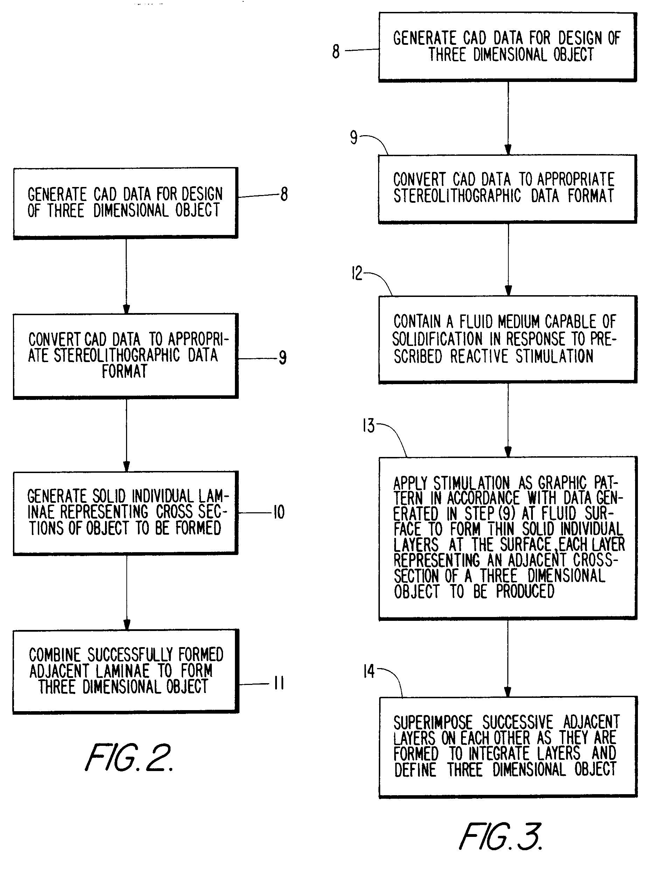

The stereolithographic system with which the apparatus and method of the preferred embodiment of the present invention is used generates three-dimensional objects by creating a crosssectional pattern of the object to be formed at a selected surface of a fluid medium, e.g., a UV curable liquid or the like, capable of altering its physical state in response to appropriate synergistic stimulation such as impinging radiation beams, or electron or other particle beam bombardment. Successive adjacent laminae, representing corresponding successive adjacent crosssections of the object, are automatically formed and integrated together to provide a step-wise laminar or thin layer buildup of the object, whereby a three-dimensional object is formed and drawn from a substantially planar or sheet-like surface of the fluid medium during the forming process. The technique is generally described in the flow charts and diagrams of FIGS. 1-5.

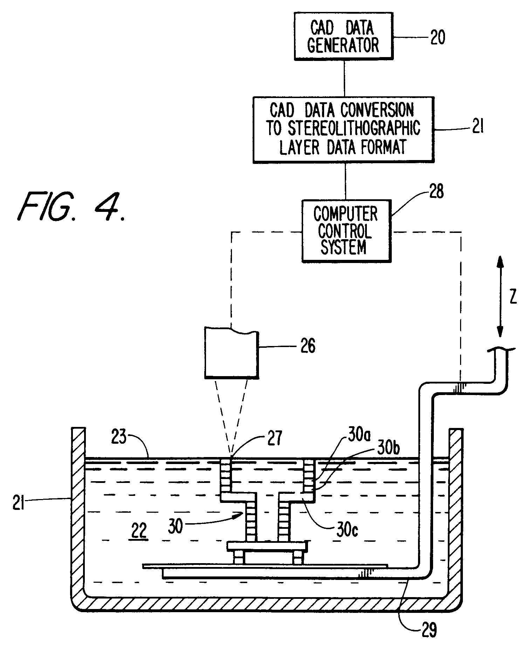

A stereolithographic system is shown in elevational crosssection in FIG. 4. A container 21 is filled with a UV curable liquid 22 or the like, to provide a designated working surface 23. A programmable source of ultraviolet light 26 or the like produces a spot of ultraviolet light 27 in the plane of surface 23. The spot 27 is movable across the surface 23 by the motion of mirrors or other optical or mechanical elements (not shown in FIG. 4) used with the light source 26. The position of the spot 27 on surface 23 is controlled by a computer control system 28. The system 28 may be under control of CAD data produced by a generator 20 in a CAD design system or the like and directed in PHIGS format or its equivalent to a computerized conversion system 21 where information defining the object is specially processed to reduce stress, curl and distortion, and increase resolution, strength and accuracy of reproduction.

A movable elevator platform 29 inside container 21 can be moved up and down selectively, the position of the platform being controlled by the system 28. As the device operates, it produces a three-dimensional object 30 by step-wise buildup of integrated laminae such as 30a, 30b, 30c.

The surface of the UV curable liquid 22 is maintained at a constant level in the container 21, and the spot of UV light 27, or other suitable form of reactive stimulation, of sufficient intensity to cure the liquid and convert it to a solid material is moved across the working surface 23 in a programmed manner. As the liquid 22 cures and solid material forms, the elevator platform 29 that was initially just below surface 23 is moved down from the surface in a programmed manner by any suitable actuator. In this way, the solid material that was initially formed is taken below surface 23 and new liquid 22 flows across the surface 23. A portion of this new liquid is, in turn, converted to solid material by the programmed UV light spot 27, and the new material adhesively connects to the material below it. This process is continued until the entire three-dimensional object 30 is formed. The object 30 is then removed from the container 21, and the apparatus is ready to produce another object. Another object can then be produced, or some new object can be made by changing the program in the computer 28.

The light source 26 of a stereolithography system according to a preferred embodiment of the invention is typically a helium-cadmium ultraviolet laser such as the Model 4240-N HeCd Multimode Laser, made by Liconix of Sunnyvale, California.

A commercial stereolithography system will have additional components and subsystems besides those previously shown in connection with the schematically depicted systems of FIGS. 1-5. For example, the commercial system would also have a frame and housing, and a control panel. It should have means to shield the operator from excess UV and visible light, and it may also have means to allow viewing of the object 30 while it is being formed. Commercial units will provide safety means for controlling ozone and noxious fumes, as well as conventional high voltage safety protection and interlocks. Some commercial units will also have means to effectively shield the sensitive electronics from electronic noise sources.

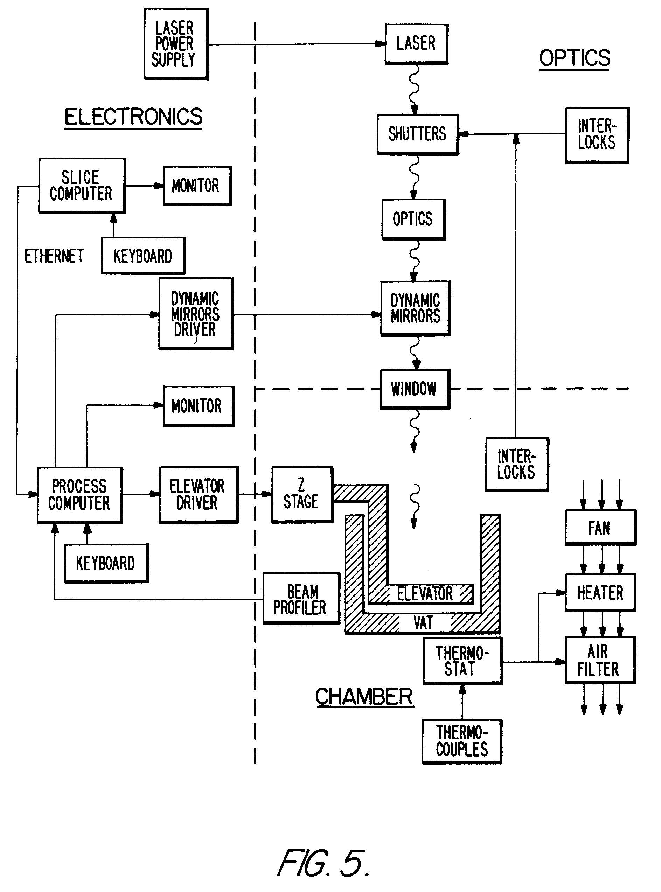

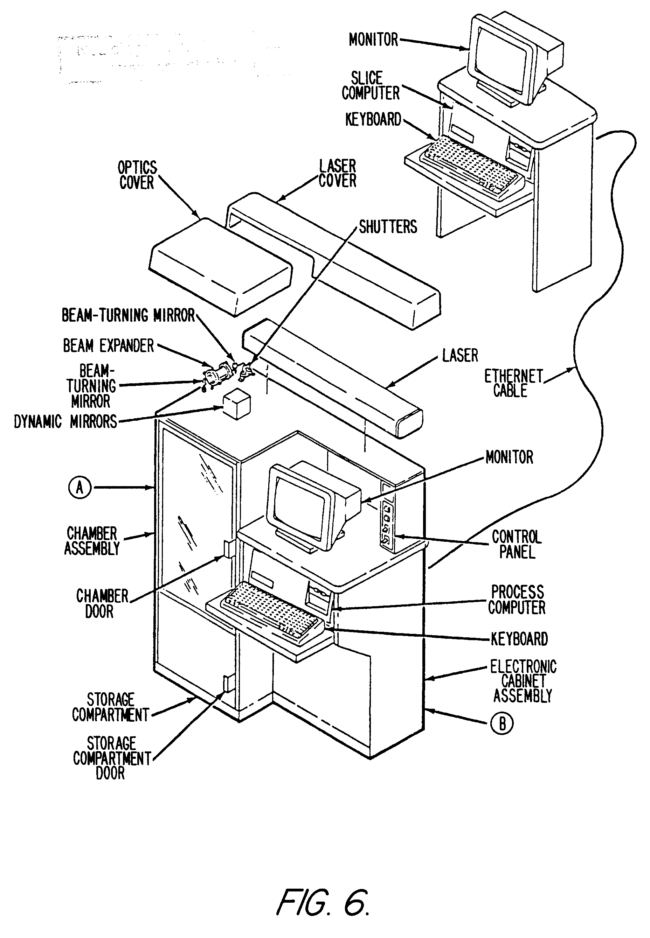

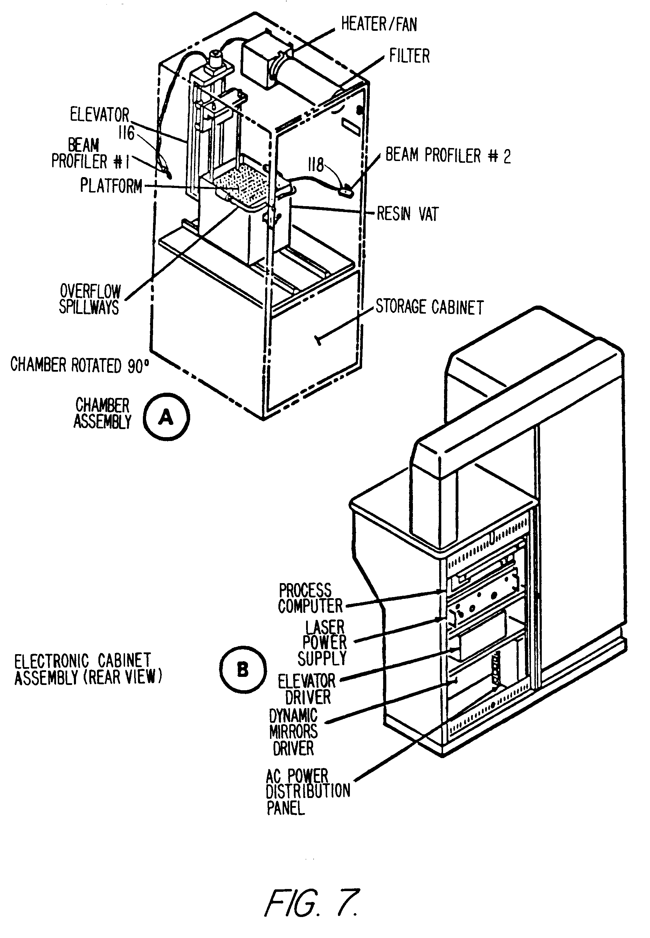

The commercialized SLA is a self-contained system that interfaces directly with the user's CAD system. A commercialized SLA containing the preferred embodiment of the apparatus of the present invention, as shown in FIGS. 6 and 7, consists of four major component groups: the SLICE computer terminal, the electronic cabinet assembly, the optics assembly, and the chamber assembly. A block diagram of the commercialized SLA is shown in FIG. 5.

The electronic cabinet assembly includes the process computer, keyboard, monitor, power supplies, ac power distribution panel, and control panel. The computer assembly includes plug-in circuit boards for control of the terminal, high-speed scanner mirrors, and vertical (z-stage) elevator. Power supplies for the laser, dynamic mirrors, and elevator motor are mounted in the lower portion of the cabinet.

The control panel includes a power on switch/indicator, a chamber light switch/indicator, a laser on indicator, and a shutter open indicator.

Operation and maintenance parameters, including fault diagnostics and laser performance information, are also typically displayed on the monitor. Operation is controlled by keyboard entries. Work surfaces around the keyboard and computer are covered with formica or the like for easy cleaning and long wear.

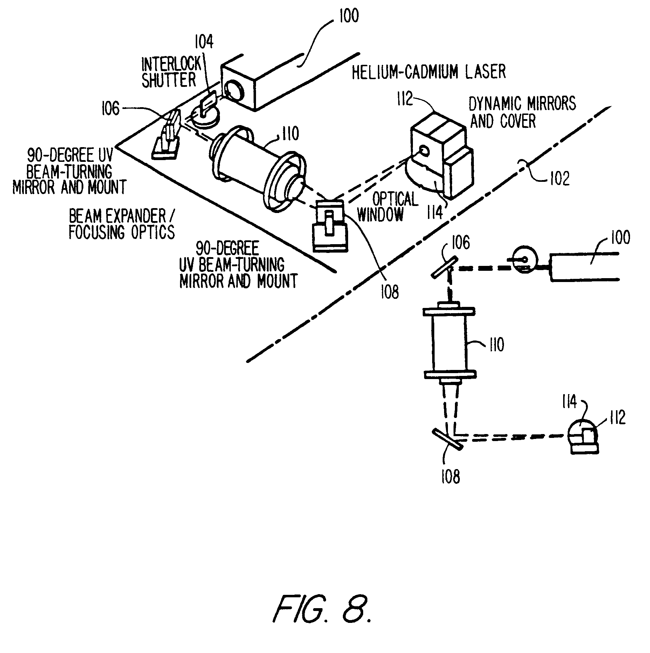

Turning to FIG. 8, the helium cadmium (HeCd) laser 100 and optical components are mounted on top of the electronic cabinet and chamber assembly 102. The laser and optics plate may be accessed for service by removing separate covers. For safety reasons, a special tool is required to unlock the cover fasteners and interlock switches are activated when the covers are removed. The interlocks activate a solenoid-controlled shutter to block the laser beam when either cover is removed.

As shown in FIG. 8, the shutter assembly 104, two ninety degree beam-turning mirrors 106, 108, a beam expander 110, an X-Y scanning mirror assembly 12, and precision optical window 114 are mounted on the optics plate. The rotary solenoid-actuated shutters are installed at the laser output and rotate to block the beam when a safety interlock is opened. The ninety degree beam-turning mirrors 106, 108 reflect the laser beam to the next optical component. The beam expander 110 enlarges and focuses the laser beam on the liquid surface. The high speed scanning mirrors direct the laser beam to trace vectors on the resin surface. The 2- mirror, 2-axis galvanometer scan heads sold by General Scanning Inc. of Watertown, Massachusetts have been found to be satisfactory for this purpose and in a preferred embodiment their Model DX-2005 servo and Model XY-0507 galvanometer X-Y scanning heads are used. A quartz window 114 between the optics enclosure and reaction chamber allows the laser beam to pass into the reaction chamber, but otherwise isolates the two regions.

The chamber assembly contains an environmentally controlled chamber, which houses a platform, resin vat, elevator, and beam profilers.

The chamber in which the object is formed is designed for operator security and to ensure uniform operating conditions. The chamber may be heated to approximately 40°C (104°F) and the air is circulated and filtered. An overhead light illuminates the reaction vat and work surfaces. An interlock on the access door activates a shutter to block the laser beam when opened.

The resin vat is designed to minimize handling of the resin. It is typically installed in the chamber on guides which align it with the elevator and platform.

The object is formed on a platform attached to the vertical axis elevator, or Z-stage. The platform is immersed in the resin vat and it is adjusted incrementally downward while the object is being formed. To remove the formed part, it is raised to a position above the vat. The platform is then disconnected from the elevator and removed from the chamber for post processing. Handling trays are usually provided to catch dripping resin.

Two beam profiler sensors 116, 118 according to the preferred embodiment of the present invention are mounted at the sides of the resin vat and the focal point of the laser optical system is adjusted to match radial sensor positions (i.e., they are mounted at a radial distance from the galvanometer scanners equal to the distance from the galvanometers to a point 7,62 mm (0.3 inches) below the surface of the liquid). (See FIG. 7). The scanning mirror is periodically commanded to direct the laser beam onto the beam profiler sensors, which measure the beam intensity profile. The data may be displayed on the terminal, either as a profile with representation of intensity values or as a single number representing the overall (integrated) beam intensity. This information is used to determine whether the mirrors should be cleaned and aligned, whether the laser should be serviced, whether the scanner mirrors have drifted, and what parameter values will yield cured vectors of the desired thickness and width.

The beam profiler sensors 116, 118 are symmetrically placed relative to the center of the resin vat. (See FIG. 7). They should preferably have similar X and Y offsets as measured from the vat center (of opposite values) although this is not required; that is to say, they are on a diagonal of the stereolithographic apparatus. In FIG. 7, the beam profiler sensors 116, 118 are seen in the corners of the chamber assembly. The distance from the second scanning mirror on the optical plate above the chamber assembly to each beam profiler sensor aperture is the focal length which equals the desired liquid to scanning mirror length plus a small increment. In the SLA-1 sold by 3D Systems, Inc. (which is shown in FIGS. 6 and 7), this liquid to scanning mirror length is approximately 68,6 cm (27 inches) and the small increment is an additional 7,62 mm (0.3 inches), therefore the focal length is approximately 69,36 cm (27.3"). The distancing of the beam profiler sensors 116, 118 from the second mirror by the desired focal length has the effect of detecting the best average focus for the designated surface of the photopolymer in the SLA-1 resin vat. At the center of the resin vat, when the photopolymer is at the desired level, the focal length of the laser beam will be 7,62 mm (0.3 inches) below the surface of the photopolymer. The focus of the beam at the surface of the photopolymer in the center of the resin vat will not vary much. At the corner of the 30,48 cm (12 inch) resin vat of the SLA-1, the focal length will be approximately 2,54 cm (1 inch) above the surface of the photopolymer. The focal length will be at the surface of the photopolymer at a circle with a 10,67 cm (4.2 inch) radius about the center of the surface of the photopolymer. The placement of the beam profiler sensor at the focal length is intended to obtain an optimal beam profile considering that the surface of the photopolymer will mostly not be at the focal length of the laser.

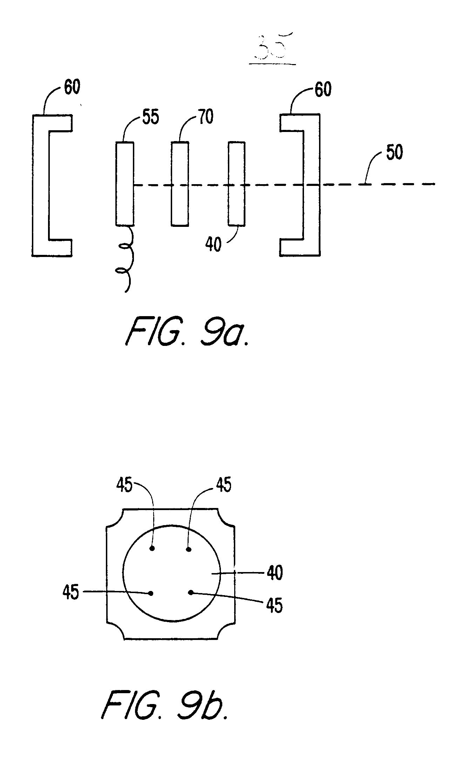

FIG. 9A is a cross-sectional view of a beam profiler sensor 35 of a preferred embodiment of the apparatus of the present invention and FIG. 9B is a top plan view of a pinhole plate used in the beam profiler sensor. The beam profiler sensor has a thin stainless steel metal plate 40 having four etched pinholes 45 of varying size. In a preferred embodiment these holes have diameters 0,0127 mm (0.0005"), 0,0254 mm (0.001"), 0,0508 mm (0.002"), and 0,1016 mm (0.004"). The pinholes each permit a small fraction of the laser beam 50 incident upon the pinhole to fall on a photodetector 55 underneath the plate 40. The purpose for providing several pinholes is to permit profiling of beams having a wide range of incident power. One of the pinholes will be best suited for measuring the intensity profile of a beam of a given incident power. For the HeCd lasers used in the SLA-1, a pinhole of 0,0508 mm (2 mil or 0.002 inch) diameter has been found to be satisfactory. The beam is scanned across a selected pinhole in an X Y array to build up a two dimensional profile of the beam intensity.

As may be seen in FIGS. 7 and especially 9A, the beam profiler sensor 35 has a two part housing 60. Light beam 50 enters from the right and moves toward the left in FIG. 9A. The beam profiler sensor is mounted in the corners of the chamber assembly compartment in such a way as to prevent the resin vat from hitting the beam profiler sensor when it is moved into and out of the compartment (see FIG. 7).

Turning to FIG. 9A the beam profiler sensor 35 comprises a split two part housing 60, pinhole plate 40, ultra-violet transmitting filter 70 that absorbs visible light and prevents spurious readings due to visible light. Filter 70 is a two millimeter thickness of Schott UG-11 filter glass which has been found to be acceptable for this purpose in a preferred embodiment. The characteristics of this filter provide reasonable transmission of light in the 300-370 nanometer wavelength region with considerably less transmittance at other wavelengths. A one millimeter thickness of HOYA U-350 filter material would also be acceptable.

Underneath the filter 70 in the beam profiler housing is a photodiode sensor 55 which detects the ultraviolet light which passes through the filter 70 from the pinhole 45. An EEG Vactec VTS 3072 super blue enhanced photodiode has been found to be acceptable. The output from this photodiode is passed to a current to voltage amplifier (not shown). An OP07 current to voltage amplifier whose implementation is well known to those skilled in the art has been found to be acceptable.

The pinhole plate 40 of the beam profiler sensor 35 is covered with a quartz filter (not shown). The quartz filter is cleanable and protects the beam profiler sensor from dust and photopolymer drips. The quartz filter should be coated to prevent internal reflections when the photosensor is not perpendicular to the beam, in order to prevent false shape measurements. Optionally a diffuser (not shown) can be used between the pinholes to aid the filter to protect the optical components from damage.

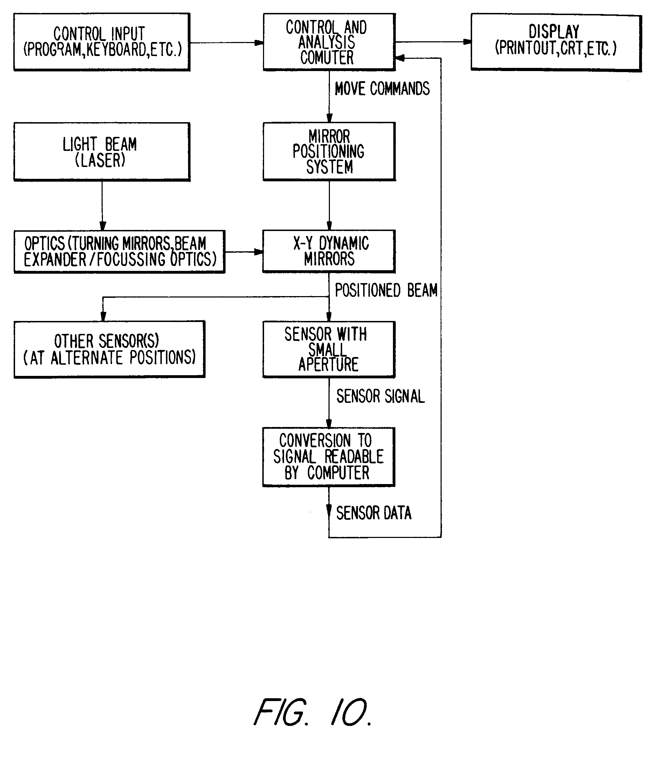

FIG. 10 is a block diagram showing the apparatus of the preferred embodiment of the present invention. Fundamental to the invention is a control and analysis computer. This computer receives inputs from a program, a keyboard or the like and may display results through a printer or terminal or the like. The control and analysis computer sends positioning commands to a mirror positioning system which controls the X Y scanner mirrors. The laser beam is focused by the optics shown in FIG. 8 to reach the X Y scanner mirrors and is directed by those mirrors to one of the beam profiler sensors. The use of two beam profiler sensors is recommended for the purpose of drift correction. The sensor signal from the beam profiler sensors is converted to a signal readable by the computer which is then sent back to the control and analysis computer to be manipulated as described hereafter.

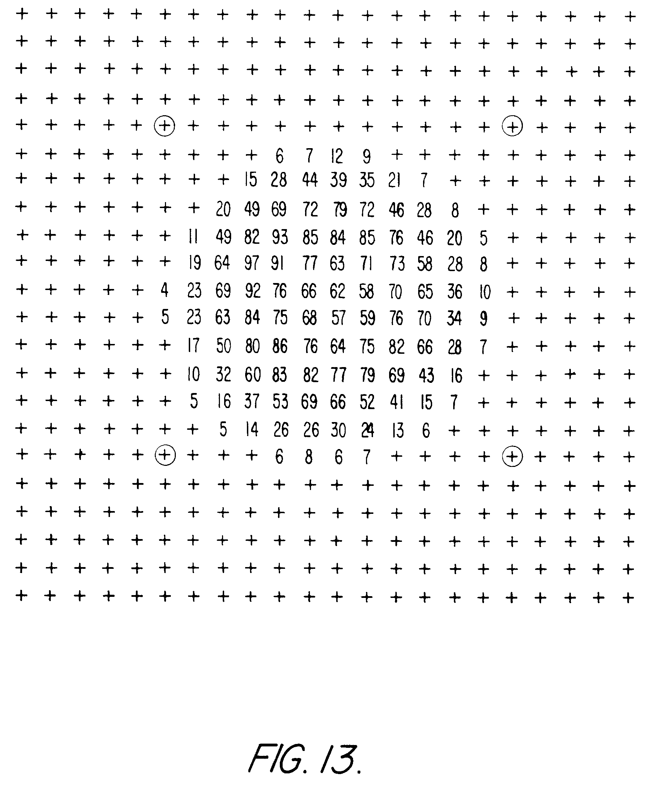

In physical terms, the beam profile method according to the present invention causes the beam to be moved to each of the points of an array on the pinhole plate centered on the best known position of the pinhole. As a result, different sectors of the beam will fall on the pinhole and will be transmitted through the same to be detected by the photodiode and converted into a numerical signal that can be analyzed by the computer. A profile of the intensity of different sectors of the beam will be built up by the computer (see FIG. 13). This is the "intensity profile" of the beam.

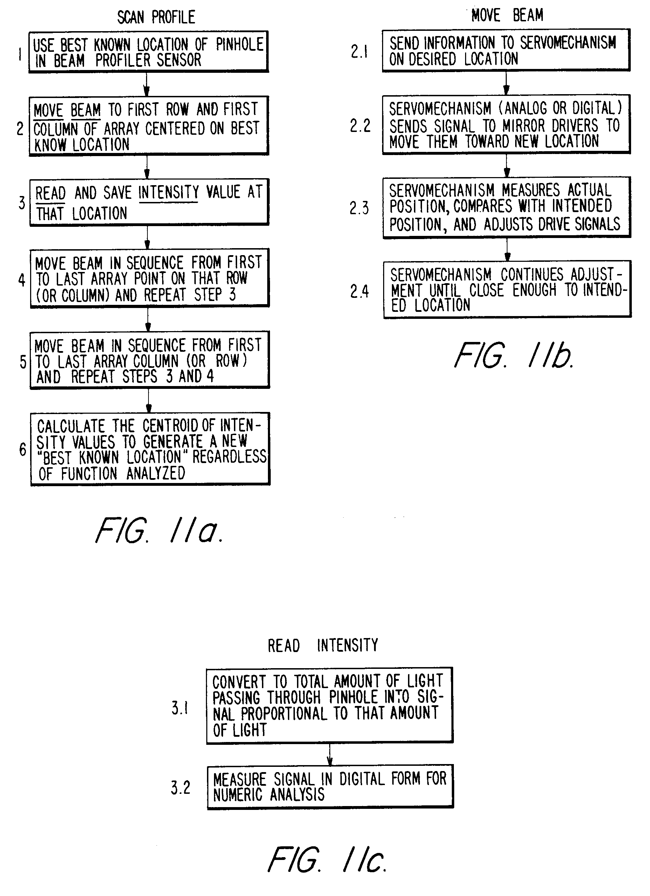

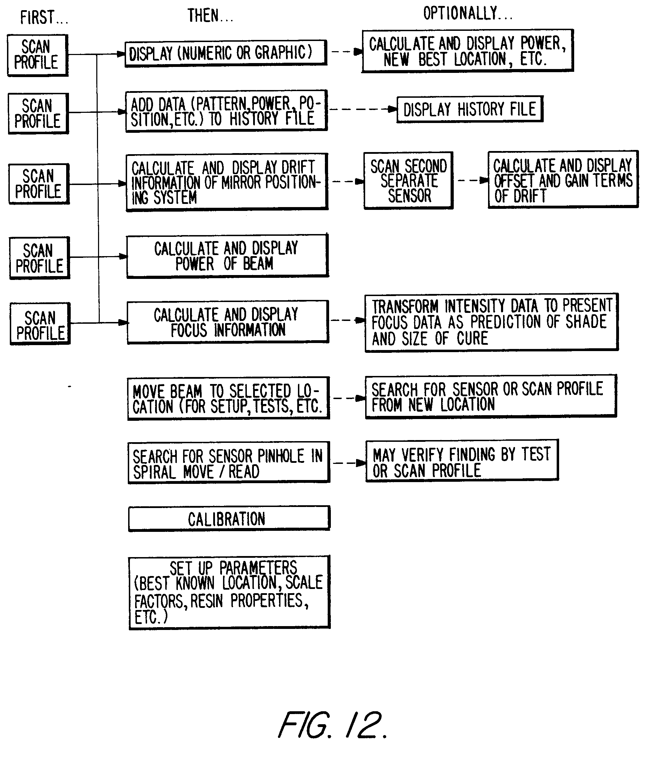

FIG. 11A is a functional block diagram showing how a beam profile is developed according to the preferred embodiment of the invention. The best known location of a pinhole on the beam profiler sensor is called up from memory by the control and analysis computer and sent to the mirror positioning system to position the X Y scanner mirrors to direct the beam at this best known location. The control and analysis computer, through the beam positioning system, moves the beam to the first row in the first column of a square array centered on the best known location. The intensity of the portion of the beam entering the pinhole as detected by the beam profiler sensor is then read and is saved as well as the mirror position commands which are associated with that intensity. The beam is then moved in sequence from the first to the last array points on a particular row or column and the reading and saving intensity value steps are repeated. The beam is then moved in sequence from the first to the last array columns or rows and the moving and reading steps are then performed down each column or row. The result is that beam intensity readings are taken for each of the positions on the array (a "position" is known to the computer as a set of mirror positioning commands). A standard analysis, performed by the control and analysis computer of the array of intensity values is usually performed to generate a new best known location of the pinhole (for use in performing the first step of the scan profile the next time) regardless of the detailed function actually being analyzed (see FIG. 12). This calculated best known position can be found with great precision by this means, to an accuracy much finer than the size of the pinhole. When an appropriate number of locations have been found and stored, the control system can use these values with two-axis linear interpolation to move the beam to those or any intermediate locations.

FIG. 11B is a functional block diagram of a method of moving a beam and carrying out the method described in connection with FIG. 10A. To move the beam, the first step is to send the beam positioning information to the servomechanism of the X Y scanner mirrors concerning the desired location. The servomechanism (which may be analog or digital) then send a signal to the mirror drivers to position the X Y scanner mirrors to a new location. The servomechanism of the X Y scanner mirrors measures the actual position of the mirror drivers and compares the actual position with the intended position and adjusts the drive signals accordingly. The adjustments are continued within specification values of the intended location.

FIG. 11C is a functional block diagram of a method of reading the intensity of a portion of a beam and carrying out the method of the preferred embodiment of the present invention. The first step is to convert the total amount of light which passes through the pinhole into a signal which is proportional to that amount of light. In the preferred embodiment, this process is performed by the photodiode which measures the light coming through the pinhole and the filter. The current from the photodiode is sent to a current to voltage amplifier which generates a signal proportional to the amount of light received by the photodiode. Amplification of the signal (which will be proportional to intensity) to provide wide dynamic range of the measurement is important to obtain small but significant readings for the edge of the beam which would otherwise be lost. The next step is to measure the signal, which is proportional to the amount of light received, after the signal is converted into a digital form for numerical analysis.

FIG. 12 is a functional block diagram showing the processes and analyses which may be coupled with the method described in FIG. 11A. As may be observed from that figure, a number of different processes and analyses may be selected from a menu, the first five of which are connected to the scan profile routine of FIG. 11A. The first step is to scan the intensity profile of the beam according to the method described in connection with FIG. 11A. The intensity profile may be displayed numerically or in the form of a graph. As an option, the power may be calculated from the intensity profile as well as a new best known location of the pinhole used. Another possible process is to add the data generated in connection with the beam intensity profile to a history file with an option of displaying the history file. A further possible process is to calculate and display drift information for the mirror positioning system which generally involves scanning a second separate sensor (in the case of the preferred embodiment, another beam profiler sensor) and then calculating and displaying the offset and gain terms of the drift. Another process is to calculate and display the power of the beam, which involves summing up the intensities of a profile and multiplying by a power conversion factor. The power conversion factor can be determined, for example, by utilizing the process with a beam of known power or by comparing calculated power to that of a calibrated sensor and determining the required gain factor. A further function is to calculate and display focus information, with a possible option of using a special transformation of the intensity data used to calculate focus information and the use of known resin properties to predict the shape and size of the cured traces of photopolymer. Another possible function is to move the beam to the desired location for set up (to make parts), tests and so forth with an option for searching for the sensor or scan profile from this new location. A useful function is to search for sensor pinholes in a spiral move-read format. This may be necessary if the best known location of the pinhole is not accurate, in case when the array is traced over the best known location of the pinhole is not detected. A further step may be to verify findings (of pinhole location) by test or scan profile. A still further function is the use of the beam profilers in calibration, which involves the measurement of the drift while obtaining a calibration map for the surface corresponding to the surface of the photopolymer. A final function is to store in the machine the parameters of best known location, scale factors, resin properties, and so forth.

FIG. 13 is a chart showing a sample intensity profile for a laser beam as generated by a preferred embodiment of the present invention. The numerical values correspond to the measured intensity of a beam from a preferred embodiment of the present invention. The numbers have been converted to integers for ease of reading the display.

The intensity profile generated by the present invention may be used to calculate the power of the beam and to predict the shape and dimension of a cured trace of photopolymer (the solidified photopolymer due to exposure to the beam of UV light), as the following discussion will demonstrate.

The intensity of the beam is measured by the beam profiling apparatus when the beam is directed at each point of an array on the pinhole plate, which is a surface generally perpendicular to the optical path taken by the beam. The X and Y directions on this surface correspond to the directions taken by the beam when one or the other of the scanning mirrors rotate.

The X and Y array coordinates are 1 to $i_{max}$ and 1 to $j_{max}$, respectively (typically $i_{max}$ and $j_{max}$ are each equal to 22).

The beam is typically stepped or moved from point to point in the array, the time for the movement being much less than the time the beam remains at a point. The distance between points is:

$$s \text{ (mm)} = \text{scanstep} / \text{scalefactor} \qquad [\text{Eq. 1}]$$

The scanstep is typically 4 "bits" and the scale factor is normally 140 bits/mm. The scanning mirrors can each take on 65535 (64K) different positions over a 40° optical beam rotation. This in turn means that 1 bit along the X or Y axis corresponds to a rotation of $6.104 \times 10^{-4}$ degrees. Since mirror to liquid distance is approximately 27" this angular rotation corresponds to a translation at the liquid surface of $2.875 \times 10^{-4}$ inches or equivalently, 137 bits/mm or approximately 140 bits/mm.

The array area must cover the full beam (measurement of the entire beam is needed for power calibration as well as to produce the maximum information concerning the beam), and must have a number of points sufficient to resolve the desired beam profile. Typically, the spacing between points in this array is less than one tenth of the beam width. The pinhole diameter should be smaller than this resolution limit.

An "element" is the portion of a beam measured when the beam is directed at a point (m,n) of the array. Each element (m,n) has an intensity reading I(m,n). The letters m,n refer to positions or points in the X, Y directions in the array, respectively. FIG. 13 shows intensity readings in an array much as discussed here.

The beam power is measured independently and the power calibration factor k is derived from the following equation:

$$k * \sum_{m,n} I(m,n) = \text{Power (watts)} \qquad [\text{Eq. 2}]$$

The power calibration factor k only applies to the selected pinhole and measuring system and laser wavelength. The independent power measurement must be made on the beam after the beam has traversed the same number of optical surfaces in the beam path. These calculations also assume that the background light signals have been eliminated and amplifier scaling compensated for.

The power/unit area at element (m,n) is given by:

$$\text{Intensity (at element m,n)} = k * I(m,n) / s^2 \text{ (watts/mm}^2) \qquad [\text{Eq. 3}]$$

This is the instantaneous intensity experienced by a small area in the (m,n) element, regardless of whether the beam is stationary or moving.

When the beam is moving uniformly at the speed v (mm/sec) along the Y axis, then each element takes a time equal to s/v to pass, and the exposure energy absorbed per unit area from the element (m,n) is:

$$\text{Exposure from element (m,n)} = k * I(m,n) / s^2 \cdot (s/v) \text{ (Joules/mm}^2) \qquad \text{[Eg. 4]}$$

This is the energy absorbed per unit area from a particular element (m,n) of the beam.

The total exposure (beam energy absorbed) as the entire beam passes an area equivalent in size to an element, as defined above, is:

$$\text{Exposure at } m = k * \sum_n I(m,n) / s^2 ) * (s/v) \text{ (Joules/mm}^2) \qquad \text{[Eg. 5]}$$

Physically speaking, this equation represents a situation in which the beam traverses in the Y direction over an area equivalent in size to an element of the beam as the term element is used above. The area is traversed by the elements of the beam corresponding to the X coordinate m, so the element-sized area at m is exposed to all elements (m,n) of the beam as n varies between 0 and $j_{max}$.

The calculations described above are based on discrete elements, but could obviously be generalized to use integrals. The movement is assumed along the Y axis for convenience. Other angles can be simply derived, and may be necessary if the beam is asymmetrical.

The speed v corresponds to parameters SS and SP as follows:

$$v = (SS / ScaleFactor)(SP / 100, 000) \text{ (mm/sec)} \qquad \text{[Eq. 6]}$$

Where:

SS = Step Size in bits/step;
ScaleFactor normally is 140 bits/mm;
SP/100,000 = Step Period in seconds (SP units are units equal to 10 microsec); and
1E6 = 1,000,000 is a conversion factor between Joules / $mm^2$ and Joules / $m^2$ or microJoules / $mm^2$

Equations 5 and 6 are combined to calculate the total exposure (power incident, i.e., energy) at the sensor or at the liquid (photopolymer) surface represented by Z=0 at a small area at position m as the beam is moved in the Y direction: Exposure at (m,z=0):

$$E(m,z=0) \;=\; \sum_n I(m,n) * \frac{k * SP * ScaleFactor * 1E6}{s * SS * 100,000} \qquad \text{[Eg. 7a]}$$

$$=\; \frac{\sum_n I(m,n) * SP * ScaleFactor * power * 10}{\sum_{m,n} I(m,n) * SS * s} \; uJ / mm^2 \qquad \text{[Eg. 7b]}$$

Finally, the absorption of the beam as it penetrates into the liquid may now be compensated for in accordance with Beer's law:

$$E(m,z) = E(m,0) * \exp(-z/lambda) \qquad \text{[Eq. 8]}$$

Where:

lambda is the penetration depth (mm);
E(m,0) is the summed exposure at the surface; and

E(m,z) is the exposure at depth z below the surface (mm).

Attenuation is assumed to have no nonlinearities or time-dependence in absorption, being represented simply by I(z)=I(z=0) * exp (-z/lambda) . It is clear that appropriate modifications can be made to the foregoing calculations to allow for deviations from the above simple absorptive behavior.

The photopolymer has been shown experimentally to cure to a gel if the exposure is greater than a critical value Ec, so for any given system the shape of a trace of cured plastic can be predicted by calculating the locus of points having exposure EC. Ec can be accurately and separately measured for each photopolymer. The "gel point" gives only the "cured" versus "not cured" boundary, and disregards the gradient in exposure (related to penetration depth) at resin depths other than the Ec boundary depth. Part strength seems to relate to the higher exposure, and so absorption characteristics should be chosen to give the best (highest) cure gradient. The gradient or penetration depth also limits the best available resolution in the Z direction, because some variation in exposure (crossing lines, etc.) is unavoidable and this results in cure depth changes with this variation in exposure.

For any X location (m) the cured depth $z_c$(m) is found from:

$$z_c(m) = lambda * 1n ( E(m,z=0) / Ec )  \qquad [Eg. 9]$$

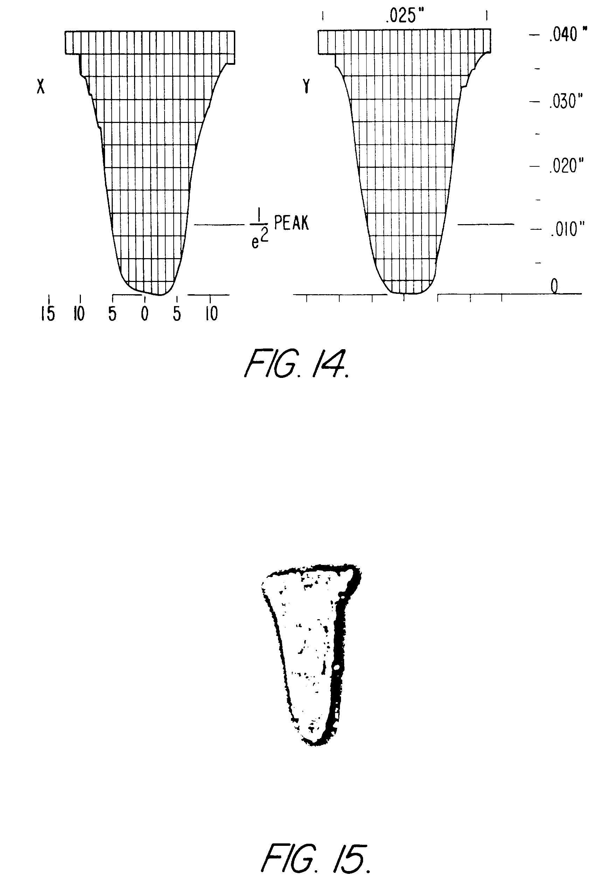

A beam profile measured with sufficient reliability and precision can be used to predict cure depths dependent only on chemical properties of a resin. FIG. 14 shows two examples of such predictions, along the X and Y axis respectively. The profile function (m,z) also permits prediction of the trace width as a function of depth (and with appropriate modifications, "beam width" and "minimum surface angle") automatically. Making and measuring "banjo tops," _i.e._, traces cured by the beam to directly determine the shape and dimensions of the cured photopolymer, will only be needed as an internal check of the system. FIG. 15 shows a cross-section of a test trace from a banjo top. FIG. 15 should be compared with FIG. 14.

To display the predicted trace profile, a scaled diagram of cure depth versus position is plotted across the beam. The scale factor for distance across the beam is easy, where one simply selects one column (or row, etc.) of the scan, with dimension s, to correspond to a pixel or graphics display block. The depth scale is then lamoda/s pixels (or blocks) for each increase in exposure by a factor of e. The only arbitrary feature is the zero of depth, related to the characteristic exposure Ec of Eg. 9, or equivalent factors from Eq. 7. The useful depth to be displayed is determined by the dynamic range of the intensity measuring system, and truncation at I(m,n)$\geq$ any appropriate value close to the noise level.

Software code listings of the software of a preferred embodiment of the present invention are attached as Appendices F and K to the subject applications.

<u>Calibration and Normalization</u>

As pointed out above, it is desirable in a stereolithographic apparatus to provide an apparatus and method for calibrating the pointing of a reaction means on a working medium for improved precision and accuracy.

Calibration procedures of a preferred embodiment of the present invention allow the creation of a "map" from a design in CAD space to drawing instructions on the real SLA. In any automated building system there will be several different sources of error needing to be corrected by calibration procedures. The present system has a pair of scanning mirrors close together, and, if left uncorrected a simple mapping of CAD dimensions to the angles of the mirrors will result in pincushion distortion. This is because the system is building on a flat surface where further from the point on the surface nearest to the mirrors, equal increments of angle will project to progressively greater distances on the surface. This happens to be the dominant distortion in the present system, and is predictable from geometry so that its correction could be calculated. However there are numerous other errors and distortions which need to be compensated, and many of them are not readily predictable.

The calibration and normalization system of the present invention is useable in a broad range of applications and systems and automatically generates a "look-up table" to enable the conversion of CAD locations into instructions which are to be sent to the scanning system so that the intended pattern will be drawn on the working surface. The term "Normalization" may be used to indicate that more than one dimension at a time is being corrected, while "Calibration" could have connotations of applying a single scale factor to a system. In a preferred embodiment, the apparatus has a single position (beam profile) sensor which is moved automatically to an array of points on the working surface, and then a record is made of the corresponding mirror instructions needed to reach each of these points. In another preferred embodiment, a square array of sensor pinholes is utilized so that no movement of the sensor was required. In yet another preferred embodiment, a linear array of pinhole sensors needing to be moved along only one axis is utilized.

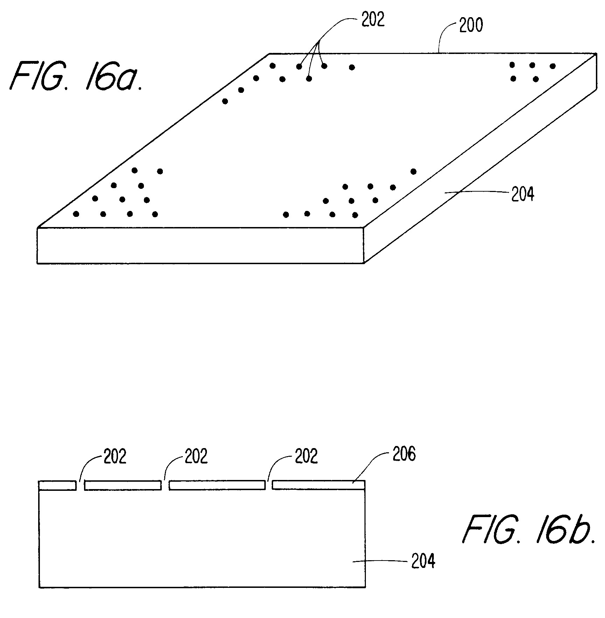

Turning to FIGS. 16A and 16B the square calibration plate 200 of a preferred embodiment of the present invention is depicted. An ultraviolet-opaque metallic coating 206 is provided by evaporation on a substrate 204 made preferably of quartz or pyrex of 3,175 mm (1/8-inch) to 6,35 mm (1/4-inch) thickness. In a preferred embodiment an array of 49 by 49 holes 202 are etched in the UV-opaque metallic coating 206 on 6,35 mm (1/4-inch) centers. Each etched hole has a diameter of 0,102 ± 0,013 mm (0.004" ± 0.0005") although it is only important that the hole be of smaller diameter than the diameter of the projected beam at the plate for best resolution. Sensors (not shown) are mounted below the plate and are arranged when the calibration plate is in use to be in the precise location of the surface of the working medium.

In a presently preferred embodiment of the invention, an array of 5 x 5 or 25 photodiodes 208 sensitive to UV light are utilized in conjunction with the calibration plate. Because UV light can only enter the plate through one of the pinholes and because the plate material tends to diffuse light that enters, light entering a pinhole will travel horizontally beyond the exact location of the pinhole so that in a preferred embodiment 25 sensors such as the sensors herein previously described are adequate to cover the entire 49 x 49 array of pinholes.

Typically a calibration procedure will be performed prior to shipping an SLA to a customer and after any physical trauma to the mirror control system which would tend to uncalibrate the SLA.

In operation the calibration procedure uses the same beam profiler methodology to obtain a "best location" of a pinhole from the centroid of the scan data.

A new "best location" is obtained for each pinhole in the case of the plate, each pinhole-column location in the case of the linear array, and each predetermined location in the case of a sensor positioned at certain predetermined locations. It is not always necessary to scan each pinhole in order to obtain a working and practically useable look-up table. In a preferred embodiment of the present invention only about 40 x 40 pinholes are located and mapped. In situations where there are smaller geometric distortions, or less precision desired, or the other sources of distortion are suitable for correction with more reliance on interpolation, fewer pinholes could be mapped. Linear interpolation relative to the X and Y locations is used to determine mirror positioning for points intermediate the "best locations" stored in the look-up table in memory. The appropriate number of pinholes will be determined from these considerations, and from the time needed to make the calibration, and from the system memory available for storing the look-up table.

Optionally and preferably the drift correction apparatus and method described farther on are used in conjunction with calibration to obtain more precise and more accurate results. Similarly, during part building the same drift correction method and apparatus are used to improve precision and accuracy.

Briefly the method of a preferred embodiment of the present invention is set forth below:

STEP 1: User inserts calibration plate into SLA building chamber with its sensor pinholes positioned where the liquid surface normally stays; user specifies the delay times between reading sensors 1 and 2 (Fixed Beam Profile Sensors 116, 118) and the Calibration Plate (deemed "Sensor 3") locations.

STEP 2: Sensors 1 and 2 are located again as they are located when the first scan profile occurs to finalize and store their apparent coordinates in terms of mirror position information.

STEP 3: Center the calibration plate by determining if the center sensor 3 leading coordinates are within acceptable tolerances. The center plate coordinates should correspond to the mirror positioning center coordinates. This configuration allows maximum equal mirror movements in all directions.

STEP 4: The gain of the calibration plate (Sensor 3) is set by reading the center hole of the plate (which is found with the find sensor algorithm defined in Beam Profile Fig. 1). The actual beam intensity is derived by reading Sensor 3 with and without the beam in the center hole. This subtracts the background noise Sensor 3 receives. The gain control is adjusted by the user until the sensor sensitivity is optimized.

STEP 5: The borders of the calibration plate are established by stepping the beam from plate holes to the borders of the plate (1 = West, 2 = North, 3 = South, and 4 = East).

A) Move in direction 1, locating holes along the way by moving a predetermined (bits/hole separation) value. Bits refer to mirror coordinate change values.

B) When the known number of holes before the border are read, one more "bits/hole separation" movement is executed.

C) If a read finds a hole there, either the gain is set incorrectly because a false hole has been read, or the hole to the right of the center hole was where the search started. Return to Step 3.

D) If no hole is detected, the left and right borders are now established.

E) The beam returns to the center hole and begins a search for the back border in a similar fashion to A-D.

F) Once all borders are established through movements 1 and 2, the values of the hole locations for movements 1, 2, 3, and 4 are used to build a "rough map of hole separations" across the plate in mirror bits. Movement 4 leaves the beam at plate hole (1,1).

STEP 6: Quick search for all plate hole locations. If any hole cannot be located the beam is left at its most probable location, as determined by the "rough map of hole separations", and prompts the user to examine for dust around the hole location. After the wait the find is resumed until the hole is found or the user aborts. The gain may be reset in this process if the user desires. If the gain is changed the user restarts the quick search at hole (1,1).

STEP 7: After the quick search locates all the plate holes a _final_ search is performed with the requested delays from Step 1. Also, on both <u>quick</u> and <u>final</u> searches the locations of sensors 1 and 2 are found to determine GAIN and OFFSET corrections to be made at the intervals (end of each row) of mirror bit movements to the same locations. These correction factors are applied proportionately to correct each of the calibration locations in a manner normalized to a single set of reference locations of the fixed sensors 1 and 2.

STEP 8: After the <u>final</u> search stores all the gain, offset, intensity, and locations date the procedure ends.

<u>Drift Correction</u>

Drift correction is a procedure which compensates for drift of, <u>inter alia</u>, the mirror positioning system by periodically checking on the apparent position of one or more beam profile sensors (herein referred to as "sensor means"). Measurements of changes in the apparent position of a single sensor allow for compensation for drift of the "zero setting" of the mirror system, two separate sensors allow additionally for correcting for otherwise uncompensated gain in the system and/or otherwise uncompensated changes in size of parts of the SLA due to thermal and other effects. Other errors can be corrected by utilization of even more sensors although in a preferred embodiment of the present invention two beam profile sensors are deemed sufficient.

In a preferred embodiment of the present invention, a calibration operation is periodically performed. In the calibration procedure, a plate having a number of holes and sensors is utilized to generate in system memory a table of mirror position settings which correspond to fixed predetermined locations on the plate.

During the time a calibration is being run, the system periodically checks on the apparent locations of two sensors. These measurements are used to correct the calibration measurements for this amount of drift, so that the values are all normalized to a "standard" pair of apparent positions of the two sensors. When later building a part, the same two sensors are again scanned periodically, and the apparent positions can be used to correct for changes in the zero and gain of the mirror system relative to the time at which the calibration was made. This procedure has been found to remove 90% of the error caused by drift of the mirrors. A description of the calibration procedure is provided earlier.

In the drift compensation method and apparatus of a preferred embodiment of the present invention two beam profile sensors capable of detecting when the laser beam is directed toward them by the mirror positioning system are mounted fixedly in predetermined locations fixed with respect to a designated surface of the solidifiable working medium upon which the reaction means impinges to solidify said medium.

Periodically the laser beam is directed toward the sensors, and sensor location output means provide a readout of the apparent location of the sensors. The current apparent location of the sensors are compared with a past apparent location of the sensors which is stored in memory and a difference indicates the need for a drift correction.

For example, when a single sensor No. 1 is in use, this sensor No. 1 had a past apparent position of X = 20, Y = 20 and a current apparent position of X = 22, Y = 22 then a drift of +2X and +2Y has occurred and the mirror positioning system can apply an appropriate correction factor in order to point the beam in the desired location. As another example, when in addition to this first sensor, a second sensor is used, then the second sensor might be read at calibration to be X = 64000, Y = 64000 and have a current apparent position of X = 64004, Y = 64003. Were this the case, in addition to a linear shift of +2X, +2Y across the entire system (the two sensors conveniently being located on a diagonal) there would also be a gain or stretching of +2X, +1Y of the apparent distance between sensors No. 1 and No. 2 and we expect and correct for proportionately different stretching for different locations relative to the sensor No. 1. In compensating, linear interpolation could be used to help the mirror positioning system compensate for the gain term in the drift error.

To achieve more accurate part-building using stereolithography, a special computer software algorithm was developed. This algorithm, known as the Drift Correction algorithm, can be considered having two parts.

The first part is code that determines the value of the variable used in drift correction. The second part is code for the application of these variables to correct for drift.

The drift correction variables are:

* the X-axis gain called     DriftGainX in our examples
* the X-axis offset        DriftOffsetX
* the Y-axis gain          DriftGainY
* the Y-axis offset         DriftOffsetY

The variables are used to compute a correction factor that is applied to all X,Y coordinate positions of the laser mirrors. This correction is applied to each axis separately and has a gain (multiplier) and offset (addition) term for each axis. It is in the form:

corrected axis value = (gain * desired axis distance from first sensor) + offset of first sensor

where the gain and offset variables map the ideal desired axis position to the corrected real-world position based on measurements.

The drift correction variables are determined at the start of each layer through the use of Beam Profiling algorithms very similar to those found in the Beam program. The position of two beam profile sensors at opposite corners of the vat is measured and calculated and compared to the ideal positions remembered in a disk data file. The differences between these two sets of profile sensors positions determines the value of the drift correction variables. Placement of the two profile sensors at the corners of the scanning field optimizes the baseline along both X and Y axes from which to measure changes in gain.

The Pascal function below is a sample for computing the values of the drift correction variables. The 'Ref' variables are the reference positions of the two beam profile sensors read from the disk data file. The 'Now' variables are the most recently determined positions of the two profile sensors. Because of dynamic changes in the physical characteristics of the laser scanning system, the positions held in the 'Now' variables will differ slightly from the ideal reference positions. The goal is to use these position differences to adjust upcoming mirror positions.

```
{
        CorrectForDrift -- compute value of drift correction
variables
}
procedure CorrectForDrift;
var
        quotient: Float Type;
begin
        DriftGainx      := (Sensor2_NowX - Sensorl_NowX) /
                          (Sensor2_RefX - Sensorl_RefX;)
        DriftOffsetX   :=  Sensorl_NowX;
        DriftgainY         (Sensor2_NowY - Sensor1_NowY)/
                          (Sensor2_RefY - Sensorl_RefY;)
        DriftOffsetY   :=  Sensorl_NowY;
end;
```

The Pascal procedure below shows how a coordinate pair can be corrected for drift once the drift correction variables have been determined. Note that the correction for each axis is separate from the other.

```
{
        DriftCorrect    -- correct coordinate pair for drift
}
procedure DriftCorrect(oldX,oldY: FloatType;var newX,newY:
FloatType);
begin
        newX :=  (oldX  -  Sensorl_RefX)  *  DriftGainX  +
DriftOffsetX;  newY := (oldY - Sensorl_RefY) * DriftgainY
+ DriftOffsetY;
end;
```

The DriftCorrect procedure is used to correct the start and the end of each drawing vector before it is converted to a "feature" which is a highly optimized form of a laser drawing used within 3D Systems software. The CorrectFor Drift is used only once per layer, after the new position of the two beam profilers has been determined.

In practice, these routines are located within a special memory resident driver (known as STEREO) that different stereolithography application programs can use. The application program is responsible for finding the profiler location, and it passes this information along to the special device driver.

| BUILD | STEREO |
|---|---|
| an application program used to build parts; it passes along profile position info for each layer | the memory-resident driver that performs several Stereolithography related tasks, one of which is drift correction |

An equivalent drift correction procedure is performed on all of the calibration points during the calibration of the SLA. In a presently preferred embodiment, drift is determined at the end of a scan of each row of predetermined fixed positions and the correction is applied through linear interpolation for that row. A method of actual software implementation of such a routine for compensation would be well within the capabilities of one of ordinary skill in the art and therefore will not be further described herein.

It will be apparent from the foregoing that, while particular forms of the invention have been illustrated and described, various modifications can be made without departing from the scope of the invention. Accordingly, it is not intended that the invention be limited, except as by the appended claims.

**Claims**

1. An apparatus for determining the location of a reaction means (27) of a stereolithographic apparatus on a designated surface (23) of a working medium (22), said stereolithographic apparatus producing three-dimensional objects (30) from said working medium (22) capable of solidification when exposed to said reaction means (27) operating in a prescribed manner upon said working medium surface (23) to solidify successive adjacent laminae (30a-c) forming said object (30), comprising:

   a) at least one sensor means (116, 118; 200) for sensing said reaction means (27) and for generating a signal in response thereto, said sensor means (116, 118; 200) being positioned at or in proximity to said designated surface (23);

   b) scanning means (112, 114) for positioning said reaction means (27) on said designated surface (23) and said sensor means (116, 118; 200); and

   c) control computer means (28) responsive to said signal for providing scanning means positioning commands for pointing said reaction means (27) to said sensor means (116, 118; 200), said scanning means positioning commands being used in positioning said reaction means (27) on said surface (23).

2. An apparatus for profiling a reaction means (27) of a stereolithographic apparatus producing three-dimensional objects (30) from a working medium (22) capable of solidification when exposed to said reaction means (27) operating in a prescribed manner upon a surface (23) of said working medium (22) to solidify successive adjacent laminae (30a-c) forming said objects (30), comprising:

   a) at least one sensor means (35; 116, 118) for sensing said reaction means (27), said sensor means (35; 116, 118) being mounted at a location defined by said surface (23), for measuring the intensity of a portion of preselected size of said reaction means (27), wherein

   b) said sensor means (35; 116, 118) measures said intensity of said reaction means portion for different portions of said reaction means (27) so as to obtain an intensity distribution of said reaction means (27).

3. The apparatus of claim 2, further comprising scanning means (112, 114) for positioning said reaction means (27) on said sensor means (35; 116, 118).

4. The apparatus of claim 1 or 3, wherein said scanning means (112, 114) for positioning said reaction means (27) comprises two rotating mirrors under computer control.

5. The apparatus of anyone of the preceding claims, wherein said reaction means (27) is a laser beam.

**6.** The apparatus of anyone of the preceding claims 1 to 4, wherein said reaction means (27) is a beam of electromagnetic radiation.

**7.** The apparatus of anyone of the preceding claims 1 to 4 or 6, wherein said reaction means (27) is a collimated beam of light.

**8.** The apparatus of claims 1 to 4, wherein said reaction means (27) is an electron beam.

**9.** The apparatus of anyone of the preceding claims 3 to 7, wherein said scanning means (112, 114) for positioning said reaction means (27) comprises two linear positioning motors.

**10.** The apparatus of claim 1, wherein said control computer means (28) comprises memory means for storing determined scanning means positioning commands corresponding to predetermined locations of said sensor means within said designated surface (23).

**11.** The apparatus of claim 10, wherein said control computer means (28) comprises processor means for carrying out linear interpolations of said determined scanning means positioning commands, said processor means providing intermediate scanning means positioning commands for directing said scanning means (112, 114).

**12.** The apparatus of anyone of the preceding claims wherein said working medium (22) is a photopolymerizable liquid.

**13.** The apparatus of anyone of the preceding claims 1 to 11, wherein said working medium (22) is a powder.

**14.** The apparatus of anyone of the preceding claims 1 to 5, wherein said reaction means (27) is a beam of electromagnetic radiation and the surface includes powdered metal capable of being sintered by application of said radiation.

**15.** The apparatus of anyone of the preceding claims 1 to 5, wherein said reaction means (27) is a beam of electromagnetic radiation and the surface includes powdered metal capable of being melted by application of said radiation.

**16.** The apparatus of anyone of the preceding claims 1 to 5, wherein said reaction means (27) is a laser beam and the surface comprises a material capable of being ablated by application of said beam.

**17.** The apparatus of any of claims 10, 11 and 12, 13, as far as they depend on claims 10 or 11, wherein said computer control means (28) further comprises:

    **a.** means for storing intensity value and scanning means positioning commands for each portion of the reaction means for each predetermined location;

    **b.** means for generating best known scanning means positioning commands corresponding to each predetermined location.

    **c.** means for using said best known scanning means positioning commands in moving the reaction means to locations on the surface.

**18.** The apparatus of anyone of the preceding claims 10 to 17, wherein said at least one sensor means (200) comprises

    a calibration plate having a plurality of predetermined paths through which said reaction means (27) is capable of travelling; and wherein

    said sensor means (200) is capable of producing said signal in response to said reaction means (27) travelling through a single one of said predetermined paths.

**19.** The apparatus of claim 1, further comprising

    **a.** means for comparing said scanning means positioning commands obtained in response to said signal from said sensor means (116, 118; 200) at a given time with scanning means positioning commands obtained in response to said signal from said sensor means (116, 118; 200) at an earlier time, to determine a drift error signal between said scanning means positioning commands at the given and the earlier times; and

**b.** means for correcting the scanning means positioning commands in response to said drift error signal.

**20.** The apparatus of claim 19, wherein the correction means provides an offset correction and a gain correction.

**21.** A method for determining the location of a reaction means (27) of a stereolithographic apparatus on a designated surface (23) of a working medium (22), said stereolithographic apparatus producing three-dimensional objects (30) from said working medium (22) capable of solidification when exposed to said reaction means (27) operating in a prescribed manner upon said working medium surface (23) to solidify successive adjacent laminae (30a-c) forming said object (30), comprising the steps of:

a) positioning at least one sensor means (116, 118; 200) at or in proximity to said designated surface (23), sensing said reaction means (27) and generating a signal in response thereto;

b) providing scanning means (112, 114) for selectively positioning said reaction means (27) on said designated surface (23) and said sensor means (116, 118; 200); and

c) providing in response to said signal scanning means positioning commands for pointing said reaction means (27) to said sensor means (116, 118; 200) and for positioning said reaction means (27) on said surface (23).

**22.** A method for profiling a reaction means (27) of a stereolithographic apparatus producing three-dimensional objects (30) from a working medium (22) capable of solidification when exposed to said reaction means (27) operating in a prescribed manner upon a surface (23) of said working medium (22) to solidify successive adjacent laminae (30a-c) forming said objects (30), comprising the steps of:

a) sensing said reaction means (27) with at least one sensor means (35; 116, 118) being mounted at a location defined by said surface (23), and measuring the intensity of a portion of preselected size of said reaction means (27); wherein
b) said intensity of said reaction means portion is measured for different portions of said reaction means (27) so as to obtain an intensity distribution of said reaction means (27).

**23.** The use of the apparatus of claim 2 for determining the cure depth of a trace of said reaction means (27) travelling across a photopolymer (22).

**24.** The use of the apparatus of claim 2 for determining the focus of said reaction means (27) on said working medium surface (23).

**25.** The use of the apparatus of claim 2 for measuring the power of said reaction means (27) on said working medium surface (23).

## Patentansprüche

**1.** Vorrichtung zur Bestimmung des Ortes eines Reaktionsmittels (27) einer stereolithographischen Vorrichtung auf einer bestimmten Oberfläche (23) eines Arbeitsmediums (22), wobei die genannte stereolithographische Vorrichtung dreidimensionale Objekte (30) aus dem genannten Arbeitsmedium (22) erzeugt, das verfestigbar ist, wenn es dem genannten Reaktionsmittel (27) ausgesetzt wird, das in einer vorgeschriebenen Weise auf die genannte Oberfläche (23) des Arbeitsmediums einwirkt, um aufeinanderfolgende benachbarte Objektschichten (30a-c) zu verfestigen, die das genannte Objekt (30) bilden, mit

a) wenigstens einem Sensormittel (116, 118; 200) zum Erfassen des genannten Reaktionsmittels (27) und zum Erzeugen eines Signales in Antwort darauf, wobei das genannte Sensormittel (116, 118; 200) bei oder in der Nähe der genannten bestimmten Oberfläche (23) angeordnet ist;

b) einem Abtastmittel (112, 114) zum Positionieren des genannten Reaktionsmittels (27) auf der genannten bestimmten Oberfläche (23) und dem genannten Sensormittel (116, 118; 200); und

c) einem Steuercomputermittel (28), das auf das genannte Signal anspricht, um Abtastmittel-Positionierbefehle bereitzustellen, um das genannte Reaktionsmittel (27) auf das genannte Sensormittel (116, 118; 200) auszurichten, wobei die genannten Abtastmittel-Positionierbefehle verwendet werden, um das genannte Reaktionsmittel (27) auf der genannten Oberfläche (23) zu positionieren.

2. Vorrichtung zur Profilierung eines Reaktionsmittels (27) einer stereolithographischen Vorrichtung, die dreidimensionale Objekte (30) aus einem Arbeitsmedium (22) herstellt, das verfestigbar ist, wenn es dem genannten Reaktionsmittel (27) ausgesetzt wird, das in einer vorgeschriebenen Weise auf eine Oberfläche (23) des genannten Arbeitsmediums (22) einwirkt, um aufeinanderfolgende benachbarte Objektschichten (30a-c) zu verfestigen, die das genannte Objekt (30) bilden, mit:

a) wenigstens einem Sensormittel (35; 116, 118) zum Erfassen des genannten Reaktionsmittels (27), wobei das genannte Sensormittel (35; 116, 118) an einem Ort befestigt wird, der durch die genannte Oberfläche (23) definiert ist, zum Messen der Intensität eines Teiles vorgewählter Größe des genannten Reaktionsmittels (27), wobei

b) das genannte Sensormittel (35; 116, 118) die genannte Intensität des genannten Reaktionsmittelteiles für unterschiedliche Teile des genannten Reaktionsmittels (27) mißt, um eine Intensitätsverteilung des genannten Reaktionsmittels (27) zu erhalten.

3. Vorrichtung nach Anspruch 2, die weiter ein Abtastmittel (112, 114) umfaßt, zum Positionieren des genannten Reaktionsmittels (27) auf dem genannten Sensormittel (35; 116, 118).

4. Vorrichtung nach Anspruch 1 oder 3, worin das genannte Abtastmittel (112, 114) zum Positionieren des genannten Reaktionsmittels (27) zwei unter Computersteuerung stehende, rotierende Spiegel umfaßt.

5. Vorrichtung nach einem der vorigen Ansprüche, worin das genannte Reaktionsmittel (27) ein Laserstrahl ist.

6. Vorrichtung nach einem der vorigen Ansprüche 1 bis 4, worin das genannte Reaktionsmittel (27) ein Strahl aus elektromagnetischer Strahlung ist.

7. Vorrichtung nach einem der vorigen Ansprüche 1 bis 4 oder 6, worin das genannte Reaktionsmittel (27) ein kollimierter Lichtstrahl ist.

8. Vorrichtung nach einem der Ansprüche 1 bis 4, worin das genannte Reaktionsmittel (27) ein Elektronenstrahl ist.

9. Vorrichtung nach einem der vorigen Ansprüche 3 bis 7, worin das genannte Abtastmittel (112, 114) zum Positionieren des genannten Reaktionsmittels (27) zwei lineare Positioniermotoren umfaßt.

10. Vorrichtung nach Anspruch 1, worin das genannte Steuercomputermittel (28) ein Speichermittel umfaßt, zum Speichern von bestimmten Abtastmittel-Positionierbefehlen, die vorbestimmten Orten des genannten Sensormittels innerhalb der genannten bestimmten Oberfläche (23) entsprechen.

11. Die Vorrichtung nach Anspruch 10, worin das genannte Steuercomputermittel (28) ein Prozessormittel umfaßt, zum Durchführen von Linearinterpolationen der genannten bestimmten Abtastmittel-Positionierbefehle, wobei das genannte Prozessormittel Zwischenabtastmittel-Positionierbefehle bereitstellt, um das genannte Abtastmittel (112, 114) zu führen.

12. Vorrichtung nach einem der vorigen Ansprüche, worin das genannte Arbeitsmedium (22) ein photopolymerisierbares Liquid ist.

13. Vorrichtung nach der vorigen Ansprüche 1 bis 11, worin das genannte Arbeitsmedium (22) ein Puder ist.

14. Vorrichtung nach einem der vorigen Ansprüche 1 bis 5, worin das genannte Reaktionsmittel (27) ein Strahl aus elektromagnetischer Strahlung ist und die Oberfläche ein puderförmiges Metall enthält, das durch Anwendung der genannten Strahlung gesintert wird.

15. Vorrichtung nach einem der vorigen Ansprüche 1 bis 5, worin das genannte Reaktionsmittel (27) ein Strahl aus elektromagnetischer Strahlung ist und die Oberfläche ein puderförmiges Metall enthält, das durch die Anwendung der genannten Strahlung geschmolzen wird.

16. Vorrichtung nach einem der vorigen Ansprüche 1 bis 5, worin das genannte Reaktionsmittel (27) ein Laserstrahl ist und die Oberfläche ein Material umfaßt, das durch die Anwendung des genannten Strahles in die Lage versetzt wird, eine Ablation durchzumachen.

**17.** Vorrichtung nach einem der Ansprüche 10, 11 und 12, 13, sofern sie sich auf die Ansprüche 10 oder 11 zurückbeziehen, worin das genannte Steuercomputermittel (28) weiterhin umfaßt:

a) ein Mittel zum Speichern von Intensitätswerten und Abtastmittel-Positionierbefehlen für jeden Teil des Reaktionsmittels für jeden vorbestimmten Ort;

b) ein Mittel zum Erzeugen von besten bekannten Abtastmittel-Positionierbefehlen, die jedem vorbestimmten Ort entsprechen,

c) ein Mittel zum Verwenden der genannten besten bekannten Abtastmittel-Positionierbefehle zum Bewegen des Reaktionsmittels zu Orten auf der Oberfläche.

**18.** Vorrichtung nach einem der vorigen Ansprüche 10 bis 17, worin das genannte wenigstens eine Sensormittel (200) umfaßt:

eine Kalibrierungsplatte, die eine Mehrzahl von vorbestimmten Pfaden aufweist, durch die das genannte Reaktionsmittel (27) wandern kann; und worin

das genannte Sensormittel (200) in der Lage ist, daß genannte Signal in Antwort auf das genannte Reaktionsmittel (27) zu erzeugen, das durch einen einzelnen der genannten vorbestimmten Pfade wandert.

**19.** Vorrichtung nach Anspruch 1, die weiter umfaßt:

a) ein Mittel zum Vergleichen der genannten Abtastmittel-Positionierbefehle, die in Antwort auf das genannte Signal von dem genannten Sensormittel (116, 118; 200) zu einer gegebenenen Zeit erhalten worden sind, mit Abtastmittel-Positionierbefehlen, die in Antwort auf das genannte Signal vom dem genannten Sensormittel (116, 118; 200) zu einer früheren Zeit erhalten wurden, um ein Driftfehlersignal zwischen den genannten Abtastmittel-Positionierbefehlen zu der gegebenen und der früheren Zeit zu bestimmen; und
b) ein Mittel zum Korrigieren der Abtastmittel-Positionierbefehle in Antwort auf das genannte Driftfehlersignal.

**20.** Vorrichtung nach Anspruch 19, worin das Korrekturmittel eine Offset-Korrektur und eine Verstärkungskorrektur bereitstellt.

**21.** Verfahren zur Bestimmung des Ortes eines Reaktionsmittels (27) einer stereolithographischen Vorrichtung auf einer bestimmten Oberfläche (23) eines Arbeitsmediums (22), wobei die genannte stereolithographische Vorrichtung dreidimensionale Objekte (30) aus dem genannten Arbeitsmedium (22) erzeugt, das verfestigbar ist, wenn es dem genannten Reaktionsmittel (27) ausgesetzt wird, das in einer vorgeschriebenen Weise auf die genannte Oberfläche (23) des Arbeitsmediums einwirkt, um aufeinanderfolgende benachbarte Objektschichten (30a-c) zu verfestigen, die das genannte Objekt (30) bilden, welches die Schritte umfaßt:

a) Positionieren von wenigstens einem Sensormittel (116, 118; 200) bei oder in der Nähe der genannten bestimmten Oberfläche (23), Erfassen des genannten Reaktionsmittels (27), und Erzeugen eines Signals in Antwort darauf;

b) Bereitstellen von einem Abtastmittel (112, 114) zum selektiven Positionierung des genannten Reaktionsmittels (27) auf der genannten bestimmten Oberfläche (23) und dem genannten Sensormittel (116, 118; 200); und

c) in Antwort auf das genannte Signal, Bereitstellen von Abtastmittel-Positionierbefehlen, um das genannte Reaktionsmittel (27) auf das genannte Sensormittel (116, 118; 200) auszurichten, und zum Positionieren des genannten Reaktionsmittels (27) auf der genannten Oberfläche (23).

**22.** Verfahren zur Profilierung eines Reaktionsmittels (27) einer stereolithographischen Vorrichtung, die dreidimensionale Objekte (30) aus einem Arbeitsmedium (22) herstellt, das verfestigbar ist, wenn es dem genannten Reaktionsmittel (27) ausgesetzt wird, das in einer vorgeschriebenen Weise auf eine Oberfläche (23) des genannten Arbeitsmediums (22) einwirkt, um aufeinanderfolgende benachbarte Objektschichten (30a-c) zu verfestigen, die das genannte Objekt (30) bilden, das die Schritte umfaßt:

a) Erfassen des genannten Reaktionsmittels (27) mit wenigstens einem Sensormittel (35; 116, 118), das an einem Ort befestigt wird, der durch die genannte Oberfläche (23) definiert ist, und Messen der Intensität eines Teiles vorgewählter Größe des genannten Reaktionsmittels (27); worin

b) die genannte Intensität des genannten Reaktionsmittelteiles für unterschiedliche Teile des genannten Reaktionsmittels (27) gemessen wird, um eine Intensitätsverteilung des genannten Reaktionsmittels (27) zu erhalten.

23. Die Verwendung der Vorrichtung nach Anspruch 2 zur Bestimmung der Aushärtetiefe einer Spur des genannten Reaktionsmittels (27), das sich über einem Photopolymer (22) bewegt.

24. Die Verwendung der Vorrichtung nach Anspruch 2 zum Bestimmen des Focus des genannten Reaktionsmittels (27) auf der genannten Oberfläche (23) des Arbeitsmediums.

25. Die Verwendung der Vorrichtung nach Anspruch 2 zum Messen der Leistung des genannten Reaktionsmittels (27) auf der genannten Oberfläche (23) des Arbeitsmediums.

## Revendications

1. Un dispositif pour déterminer la position d'un moyen de réaction (27) d'un dispositif stéréolithographique sur une surface désignée (23) d'un milieu de travail (22), ce dispositif stéréolithographique produisant des objets tridimensionnels (30) à partir du milieu de travail (22) susceptible de solidification lorsqu'il est exposé au moyen de réaction agissant d'une manière prescrite sur la surface du milieu de travail (23) pour solidifier des strates successives adjacentes (30a-c) formant ledit objet (30), comprenant :

   a) au moins un moyen détecteur (116, 118 ; 200) pour détecter le moyen de réaction (27) et pour produire un signal en réponse à cette détection, ce moyen détecteur (116, 118 ; 200) étant positionné à l'endroit de ladite surface désignée (23) ou à proximité ;
   b) un moyen de balayage (112, 114) pour positionner le moyen de réaction (27) sur la surface désignée (23) et le moyen détecteur (116, 118 ; 200) ; et
   c) un moyen informatique de commande (28) fonctionnant en réponse audit signal pour produire des ordres de positionnement du moyen de balayage afin de pointer le moyen de réaction (27) vers le moyen détecteur (116, 118 ; 200), ces ordres de positionnement du moyen détecteur étant utilisés pour positionner le moyen de réaction (27) sur la surface (23).

2. Un dispositif pour profiler un moyen de réaction (27) d'un dispositif stéréolithographique produisant des objets tridimensionnels (30) à partir d'un milieu de travail (22) susceptible de solidification lorsqu'il est exposé au moyen de réaction (27) agissant d'une manière prescrite sur une surface (23) du milieu de travail (22) afin de solidifier des strates adjacentes successives (30a-c) formant lesdits objets, comprenant :

   a) au moins un moyen détecteur (35 ; 116, 118) pour détecter le moyen de réaction (27), ce moyen détecteur (35 ; 116, 118) étant monté en une position définie par ladite surface (23), pour mesurer l'intensité d'une partie de dimension choisie à l'avance du moyen de réaction (27), où
   b) le moyen détecteur (35 ; 116, 118) mesure ladite intensité de la partie du moyen de réaction pour différentes parties du moyen de réaction (27) afin d'obtenir une distribution d'intensité du moyen de réaction (27).

3. Le dispositif de la revendication 2, comprenant en outre un moyen de balayage (112, 114) pour positionner le moyen de réaction (27) sur le moyen détecteur (35; 116, 118).

4. Le dispositif de la revendication 1 ou 3, dans lequel le moyen de balayage (112, 114) pour positionner le moyen de réaction comprend deux miroirs tournants commandés par ordinateur.

5. Le dispositif de l'une quelconque des revendications précédentes, dans lequel le moyen de réaction (27) est un faisceau laser.

6. Le dispositif de l'une quelconque des revendications précédentes 1 à 4, dans lequel le moyen de réaction (27) est un faisceau de rayonnement électromagnétique.

7. Le dispositif de l'une quelconque des revendications précédentes 1 à 4, ou 6, dans lequel le moyen de réaction (27) est un faisceau de lumière collimaté.

8. Le dispositif des revendications 1 à 4, dans lequel le moyen de réaction (27) est un faisceau d'électrons.

9. Le dispositif de l'une quelconque des revendications précédentes 3 à 7, dans lequel le moyen de balayage (112, 114) pour positionner le moyen de réaction (27) comprend deux moteurs linéaires de positionnement.

10. Le dispositif de la revendication 1, dans lequel le moyen informatique de commande (28) comprend un moyen mémoire pour mémoriser des ordres de positionnement déterminés du moyen de balayage correspondant à des positions prédéterminées du moyen détecteur dans ladite surface (23).

11. Le dispositif de la revendication 10, dans lequel le moyen informatique de commande (28) comprend un moyen processeur pour exécuter des interpolations linéaires des ordres de positionnement déterminés du moyen de balayage, ce moyen processeur donnant des ordres de positionnement intermédiaire du moyen de balayage pour diriger ce moyen de balayage (112, 114).

12. Le dispositif de l'une quelconque des revendications précédentes, dans lequel le milieu de travail (22) est un liquide photopolymérisable.

13. Le dispositif de l'une quelconque des revendications précédentes 1 à 11, dans lequel le milieu de travail (22) est une poudre.

14. Le dispositif de l'une quelconque des revendications précédentes 1 à 5, dans lequel le moyen de réaction (27) est un faisceau de rayonnement électromagnétique et la surface comprend du métal pulvérulent susceptible de frittage par application de ce rayonnement.

15. Le dispositif de l'une quelconque des revendications précédentes 1 à 5, dans lequel le moyen de réaction (27) est un faisceau de rayonnement électromagnétique et la surface comprend du métal pulvérulent susceptible de fusion par application de ce rayonnement.

16. Le dispositif de l'une quelconque des revendications précédentes 1 à 5, dans lequel le moyen de réaction (27) est un faisceau laser et la surface comprend un matériau susceptible d'ablation par application de ce faisceau.

17. Le dispositif de l'une des revendications 10, 11 et 12, 13, prises en dépendance des revendications 10 ou 11, dans lequel le moyen informatique de commande (28) comprend en outre :

a) un moyen pour mémoriser une valeur d'intensité et des ordres de positionnement du moyen de balayage pour chaque partie du moyen de réaction pour chaque position prédéterminée ;
b) un moyen pour produire les meilleurs ordres connus de positionnement du moyen de balayage correspondant à chaque position prédéterminée ;
c) un moyen pour utiliser ces meilleurs ordres connus de positionnement du moyen de balayage pour déplacer le moyen de réaction vers des positions sur la surface.

18. Le dispositif de l'une quelconque des revendications précédentes 10 à 17, dans lequel ledit moyen détecteur au moins (200) comprend :

une plaque de calibration avec une pluralité de trajets prédéterminés le long desquels le moyen de réaction (27) est capable de se déplacer ; et dans lequel
le moyen détecteur (200) est capable de produire ledit signal en réponse au déplacement du moyen de réaction le long d'un seul de ces trajets prédéterminés.

19. Le dispositif de la revendication 1, comprenant en outre :

a. un moyen pour comparer les ordres de positionnement du moyen de balayage obtenus en réponse audit signal provenant du moyen détecteur (116, 118 ; 200) à un instant donné avec des ordres de positionnement du moyen de balayage obtenus en réponse audit signal provenant du moyen détecteur (116, 118 ; 200) à un instant antérieur, pour déterminer un signal d'erreur de dérive entre ces ordres de positionnement du moyen de balayage aux instants donné et antérieur ; et
b. un moyen pour corriger les ordres de positionnement du moyen de balayage en réponse à ce signal d'erreur de dérive.

**20.** Le dispositif de la revendication 19, dans lequel le moyen de correction produit une correction d'offset et une correction de gain.

**21.** Un procédé pour déterminer la position d'un moyen de réaction (27) d'un dispositif stéréolithographique sur une surface désignée (23) d'un milieu de travail (22), ce dispositif stéréolithographique produisant des objets tridimensionnels (30) à partir du milieu de travail (22) susceptible de solidification lorsqu'il est exposé au moyen de réaction agissant d'une manière prescrite sur la surface du milieu de travail (23) pour solidifier des strates successives adjacentes (30a-c) formant ledit objet (30), comprenant les étapes consistant à :

a) positionner au moins un moyen détecteur (116, 118 ; 200) à l'endroit de la surface désignée (23) ou à proximité de celle-ci, détecter le moyen de réaction (27) et produire un signal en réponse à cette détection ;
b) mettre à disposition un moyen de balayage (112, 114) pour positionner sélectivement le moyen de réaction (27) sur la surface désignée (23) et le moyen détecteur (116, 118; 200) ; et
c) produire en réponse audit signal des ordres de positionnement du moyen de balayage pour pointer le moyen de réaction (27) vers le moyen détecteur (116, 118 ; 200) et pour positionner le moyen de réaction (27) sur ladite surface (23).

**22.** Un procédé pour profiler un moyen de réaction (27) d'un dispositif stéréolithographique produisant des objets tridimensionnels (30) à partir d'un milieu de travail (22) susceptible de solidification lorsqu'il est exposé au moyen de réaction (27) agissant d'une manière prescrite sur une surface (23) du milieu de travail (22) afin de solidifier des strates adjacentes successives (30a-c) formant lesdits objets, comprenant les étapes consistant à :

a) détecter le moyen de réaction (27) avec au moins un moyen détecteur (35 ; 116, 118) monté en une position définie par ladite surface (23), et mesurer l'intensité d'une partie de dimension choisie à l'avance du moyen de réaction (27) ; dans lequel
b) ladite intensité de la partie du moyen de réaction est mesurée pour différentes parties du moyen de réaction (27) afin d'obtenir une distribution d'intensité du moyen de réaction (27).

**23.** L'utilisation du dispositif de la revendication 2 pour déterminer la profondeur de durcissement d'une trace du moyen de réaction (27) se déplaçant au sein d'un photopolymère (22).

**24.** L'utilisation du dispositif de la revendication 2 pour déterminer la focalisation du moyen de réaction sur la surface du milieu de travail (23).

**25.** L'utilisation du dispositif de la revendication 2 pour mesurer la puissance du moyen de réaction (27) sur la surface du milieu de travail (23).

FIG. 1.

GENERATE CAD DATA FOR DESIGN
OF THREE DIMENSIONAL OBJECT — 8

CONVERT CAD DATA TO APPROPRI-
ATE STEREOLITHOGRAPHIC DATA
FORMAT — 9

GENERATE SOLID INDIVIDUAL LAM-
INAE REPRESENTING CROSS SEC-
TIONS OF OBJECT TO BE FORMED — 10

COMBINE SUCCESSFULLY FORMED
ADJACENT LAMINAE TO FORM
THREE DIMENSIONAL OBJECT — 11

*FIG. 2.*

8 — GENERATE CAD DATA FOR DESIGN OF
THREE DIMENSIONAL OBJECT

9 — CONVERT CAD DATA TO APPROPRIATE
STEREOLITHOGRAPHIC DATA FORMAT

12 — CONTAIN A FLUID MEDIUM CAPABLE OF
SOLIDIFICATION IN RESPONSE TO PRE-
SCRIBED REACTIVE STIMULATION

13 — APPLY STIMULATION AS GRAPHIC PAT-
TERN IN ACCORDANCE WITH DATA GEN-
ERATED IN STEP (9) AT FLUID SUR-
FACE TO FORM THIN SOLID INDIVIDUAL
LAYERS AT THE SURFACE, EACH LAYER
REPRESENTING AN ADJACENT CROSS-
SECTION OF A THREE DIMENSIONAL
OBJECT TO BE PRODUCED

14 — SUPERIMPOSE SUCCESSIVE ADJACENT
LAYERS ON EACH OTHER AS THEY ARE
FORMED TO INTEGRATE LAYERS AND
DEFINE THREE DIMENSIONAL OBJECT

*FIG. 3.*

FIG. 4.

FIG. 5.

*FIG. 6.*

FIG. 7.

FIG. 8.

FIG. 9a.

FIG. 9b.

EP 0 375 097 B1

```
┌─────────────────────┐      ┌──────────────┐      ┌──────────────────────┐
│   CONTROL INPUT     │─────▶│ CONTROL AND  │─────▶│      DISPLAY         │
│(PROGRAM,KEYBOARD,ETC)│      │  ANALYSIS    │◀─    │(PRINTOUT,CRT,ETC.)   │
└─────────────────────┘      │  COMUTER     │   │  └──────────────────────┘
                             └──────────────┘   │
                                   │ MOVE COMMANDS
                                   ▼            │
┌─────────────────────┐      ┌──────────────┐   │
│   LIGHT BEAM        │      │   MIRROR     │   │
│    (LASER)          │      │ POSITIONING  │   │
└─────────────────────┘      │   SYSTEM     │   │
         │                   └──────────────┘   │
         ▼                          │           │
┌─────────────────────┐      ┌──────────────┐   │
│OPTICS(TURNING MIRRORS,BEAM│─▶│ X-Y DYNAMIC  │   │
│EXPANDER/FOCUSSING OPTICS) │  │   MIRRORS    │   │
└─────────────────────┘      └──────────────┘   │
      │                             │ POSITIONED BEAM
      ▼                             ▼           │
┌─────────────────────┐      ┌──────────────┐   │
│  OTHER SENSOR(S)    │      │ SENSOR WITH  │   │
│(AT ALTERNATE POSITIONS)│    │    SMALL     │   │
└─────────────────────┘      │  APERTURE    │   │
                             └──────────────┘   │
                                   │ SENSOR SIGNAL
                                   ▼            │
                             ┌──────────────┐   │
                             │ CONVERSION TO│   │
                             │SIGNAL READABLE│  │
                             │ BY COMPUTER  │   │
                             └──────────────┘   │
                                   │ SENSOR DATA │
                                   └────────────┘
```

*FIG. 10.*

EP 0 375 097 B1

SCAN PROFILE

1 USE BEST KNOWN LOCATION OF PINHOLE IN BEAM PROFILER SENSOR

2 MOVE BEAM TO FIRST ROW AND FIRST COLUMN OF ARRAY CENTERED ON BEST KNOW LOCATION

3 READ AND SAVE INTENSITY VALUE AT THAT LOCATION

4 MOVE BEAM IN SEQUENCE FROM FIRST TO LAST ARRAY POINT ON THAT ROW (OR COLUMN) AND REPEAT STEP 3

5 MOVE BEAM IN SEQUENCE FROM FIRST TO LAST ARRAY COLUMN (OR ROW) AND REPEAT STEPS 3 AND 4

6 CALCULATE THE CENTROID OF INTEN- SITY VALUES TO GENERATE A NEW "BEST KNOWN LOCATION" REGARDLESS OF FUNCTION ANALYZED

FIG. IIa.

MOVE BEAM

2.1 SEND INFORMATION TO SERVOMECHANISM ON DESIRED LOCATION

2.2 SERVOMECHANISM (ANALOG OR DIGITAL) SENDS SIGNAL TO MIRROR DRIVERS TO MOVE THEM TOWARD NEW LOCATION

2.3 SERVOMECHANISM MEASURES ACTUAL POSITION, COMPARES WITH INTENDED POSITION, AND ADJUSTS DRIVE SIGNALS

2.4 SERVOMECHANISM CONTINUES ADJUST- MENT UNTIL CLOSE ENOUGH TO INTEND- ED LOCATION

FIG. IIb.

READ INTENSITY

3.1 CONVERT TO TOTAL AMOUNT OF LIGHT PASSING THROUGH PINHOLE INTO SIG- NAL PROPORTIONAL TO THAT AMOUNT OF LIGHT

3.2 MEASURE SIGNAL IN DIGITAL FORM FOR NUMERIC ANALYSIS

FIG. IIc.

31

FIRST...

| SCAN PROFILE |
| SCAN PROFILE |
| SCAN PROFILE |
| SCAN PROFILE |
| SCAN PROFILE |

THEN...

DISPLAY (NUMERIC OR GRAPHIC)

ADD DATA (PATTERN, POWER, PO-SITION, ETC.) TO HISTORY FILE

CALCULATE AND DISPLAY DRIFT INFORMATION OF MIRROR POSITION-ING SYSTEM

CALCULATE AND DISPLAY POWER OF BEAM

CALCULATE AND DISPLAY FOCUS INFORMATION

MOVE BEAM TO SELECTED LO-CATION (FOR SETUP, TESTS, ETC.

SEARCH FOR SENSOR PINHOLE IN SPIRAL MOVE / READ

CALIBRATION

SET UP PARAMETERS (BEST KNOWN LOCATION, SCALE FACTORS, RESIN PROPERTIES, ETC.)

OPTIONALLY...

CALCULATE AND DISPLAY POWER, NEW BEST LOCATION, ETC.

DISPLAY HISTORY FILE

SCAN SECOND SEPARATE SENSOR

CALCULATE AND DISPLAY OFFSET AND GAIN TERMS OF DRIFT

TRANSFORM INTENSITY DATA TO PRESENT FOCUS DATA AS PREDICTION OF SHADE AND SIZE OF CURE

SEARCH FOR SENSOR OR SCAN PROFILE FROM NEW LOCATION

MAY VERIFY FINDING BY TEST OR SCAN PROFILE

*FIG. 12.*

```
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  + (+) +  +  +  +  +  +  +  +  +  +  + (+) +  +  +  +
+  +  +  +  +  +  +  +  +  6  7  12  9  +  +  +  +  +  +  +  +  +
+  +  +  +  +  +  +  +  15  28  44  39  35  21  7  +  +  +  +  +  +  +
+  +  +  +  +  +  +  20  49  69  72  79  72  46  28  8  +  +  +  +  +  +
+  +  +  +  +  +  11  49  82  93  85  84  85  76  46  20  5  +  +  +  +  +
+  +  +  +  +  +  19  64  97  91  77  63  71  73  58  28  8  +  +  +  +  +
+  +  +  +  +  4  23  69  92  76  66  62  58  70  65  36  10  +  +  +  +  +
+  +  +  +  +  5  23  63  84  75  68  57  59  76  70  34  9  +  +  +  +  +
+  +  +  +  +  +  17  50  80  86  76  64  75  82  66  28  7  +  +  +  +  +
+  +  +  +  +  +  10  32  60  83  82  77  79  69  43  16  +  +  +  +  +  +
+  +  +  +  +  +  5  16  37  53  69  66  52  41  15  7  +  +  +  +  +  +
+  +  +  +  +  +  +  5  14  26  26  30  24  13  6  +  +  +  +  +  +  +
+  +  +  +  + (+) +  +  +  6  8  6  7  +  +  +  + (+) +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
+  +  +  +  +  +  +  +  +  +  +  +  +  +  +  +  +  +  +  +  +  +
```

FIG. 13.

FIG. 14.

FIG. 15.

FIG. 16a.

FIG. 16b.